# EUROPEAN PATENT APPLICATION

(11) **EP 4 825 229 A1**
(43) Date of publication of application: **21.10.2026**
(21) Application number: 23961456.3
(22) Date of filing: 13.12.2023
(51) Int. Cl.: A24F 40/53

(54) **POWER SUPPLY UNIT FOR AEROSOL GENERATING DEVICE**

(71) Applicant: Japan Tobacco Inc., Tokyo 105-6927 (JP)
(72) Inventor: NAGAHAMA, Toru, Tokyo 130-8603 (JP)
(74) Representative: Hoffmann Eitle
(86) International application number: PCT/JP2023/044701
(87) International publication number: WO 2025/126390

(57) **Abstract**

A power supply unit (110) for an inhalation device (100) comprises a power source unit (111) and a control unit (116) configured to control at least one of charging and discharging of the power source unit (111). The power source unit (111) is replaceably and removably mounted in the power supply unit (110). The control unit (116) is capable of performing identification processing for identifying the type of power source unit (111) mounted in the power supply unit (110, and control value modification processing for modifying, on the basis of the type of power source unit (111) identified in the identification processing, at least one control value used to control the power source unit (111). At least one of the control values used for controlling the power source unit (111) is not modified by the control value modification processing.

## Description

### TECHNICAL FIELD

The present disclosure relates to a power supply unit for an aerosol-generating device.

### BACKGROUND ART

Inhalation devices that generate an aerosol with added flavor components and allow a user to inhale the generated aerosol, for example, are conventionally known. This kind of inhalation device typically generates the aerosol by heating an aerosol source by means of a heating unit, which is an electrically-resistive or inductively-heated heater, by supplying the heating unit with power from a power source such as a rechargeable battery.

In this type of inhalation device, it is known that the battery can be replaced by the user, as in the inhalation devices described in PTL 1 to 5.

### CITATION LIST

### PATENT LITERATURE

PTL 1: CN 107373765 A
PTL 2: CN 208480616 U
PTL 3: CN 206507325 U
PTL 4: CN 204407377 U
PTL 5: CN 209609859 U

### SUMMARY OF INVENTION

### PROBLEM TO BE SOLVED BY THE INVENTION

In inhalation devices in which the battery can be replaced by the user, in some cases the battery is replaced with a different type of battery. In this case, in the control of the battery in the inhalation device, the optimal control values may vary depending on the specifications and characteristics of the type of battery mounted in the inhalation device. Therefore, in the control of the battery in the inhalation device, it is desirable to identify the type of battery mounted in the inhalation device in order to provide optimal control in accordance with the specifications and characteristics of the type of battery mounted in the inhalation device, and to set control values to be used to control the battery to appropriate values in accordance with the type of battery.

The present disclosure discloses a power supply unit for an aerosol-generating device that can appropriately control a power source unit depending on the type of power source unit mounted in the power supply unit, while minimizing the necessary rewriting of control values and reducing the load on the control unit to prolong the lifespan thereof.

### SOLUTION TO PROBLEM

A power supply unit for an aerosol-generating device according to the present disclosure generates an aerosol by heating an aerosol source, and comprises:
a power source unit; and
a control unit configured to control at least one of charging and discharging of the power source unit,
wherein
the power source unit is replaceably and removably mounted in the power supply unit, and
the control unit can perform:
   identification processing for identifying the type of power source unit mounted in the power supply unit, and
   control value modification processing for modifying, on the basis of the type of power source unit identified in the identification processing, at least one control value used to control the power source unit,
      and
   at least one of the control values used for controlling the power source unit is not modified by the control value modification processing.

### ADVANTAGEOUS EFFECTS OF INVENTION

By virtue of the power supply unit for an aerosol-generating device according to the present disclosure, the power source unit can be controlled appropriately in accordance with the type of power source unit, and since the rewriting of the control values can be reduced to the minimum necessary, the load on the control unit can be reduced and the service life of the control unit can be extended.

### BRIEF DESCRIPTION OF DRAWINGS

Fig. 1 is a schematic diagram schematically showing a first configuration example of an inhalation device according to the present disclosure.
Fig. 2 is a schematic diagram schematically showing a second configuration example of an inhalation device according to the present disclosure.
Fig. 3 is an overall oblique view of the inhalation device according to the present disclosure.
Fig. 4 is a schematic diagram illustrating operating modes of the inhalation device according to the present disclosure.
Fig. 5 is a schematic diagram illustrating a first example of a mode of insertion/removal of the power source unit in the inhalation device according to the present disclosure.
Fig. 6 is a schematic diagram illustrating a second example of a mode of insertion/removal of the power source unit in the inhalation device according to the present disclosure.
Fig. 7 is a schematic diagram illustrating a third example of a mode of insertion/removal of the power source unit in the inhalation device according to the present disclosure.
Fig. 8 is a flowchart showing a control flow when the power source unit is replaced in the inhalation device according to the present disclosure.
Fig. 9 is a flowchart showing a first example of a mode for determining whether the power source unit has been replaced in the inhalation device according to the present disclosure.
Fig. 10 is a flowchart showing a second example of a mode for determining whether the power source unit has been replaced in the inhalation device according to the present disclosure.
Fig. 11 is a schematic diagram illustrating a first example of a method for identifying the type of power source unit mounted in the power supply unit in the inhalation device according to the present disclosure.
Fig. 12 is a schematic diagram illustrating a second example of a method for identifying the type of power source unit mounted in the power supply unit in the inhalation device according to the present disclosure.
Fig. 13 is a schematic diagram illustrating a third example of a method for identifying the type of power source unit mounted in the power supply unit in the inhalation device according to the present disclosure.
Fig. 14 is a schematic diagram schematically showing one configuration example of the part of the inhalation device according to the present disclosure that relates to charging and discharging of the power source unit.
Fig. 15 is a flowchart illustrating processing for modifying various control values used to control the power source unit, performed by the control unit of the inhalation device according to the present disclosure;
Fig. 16 is a flowchart illustrating the flow for determining whether heating control is possible or not, performed by the control unit of the inhalation device according to the present disclosure;
Fig. 17 is a diagram showing the change in the output voltage of the power source unit when the user initiates a heating start operation and power is supplied to the heating unit for a short period of time, for a case in which a type a power source unit is mounted in the inhalation device according to the present disclosure, and a case in which a type b power source unit is mounted.
Fig. 18 is a diagram showing the charging control of the power source unit in the inhalation device according to the present disclosure.

### EMBODIMENTS OF THE INVENTION

Embodiments of the power supply unit for an aerosol-generating device, control method, and control program according to the present disclosure will be described in detail below with reference to the drawings. The embodiments described below are an exemplary case in which the aerosol-generating device according to the present disclosure is applied to an inhalation device. Note that the drawings are to be viewed in the orientation of the reference signs. Furthermore, hereinafter, identical or similar elements may be assigned identical or similar reference signs, and descriptions thereof may be omitted or simplified as appropriate.

### [1. Configuration example of inhalation device]

The inhalation device of this embodiment, which constitutes an example of the aerosol-generating device of the present disclosure, is a device for generating a substance to be inhaled by a user. Hereinafter, the substance generated by the inhalation device is be described as being an aerosol. Alternatively, the substance generated by the inhalation device may be a gas.

### <1-1. First configuration example of inhalation device>

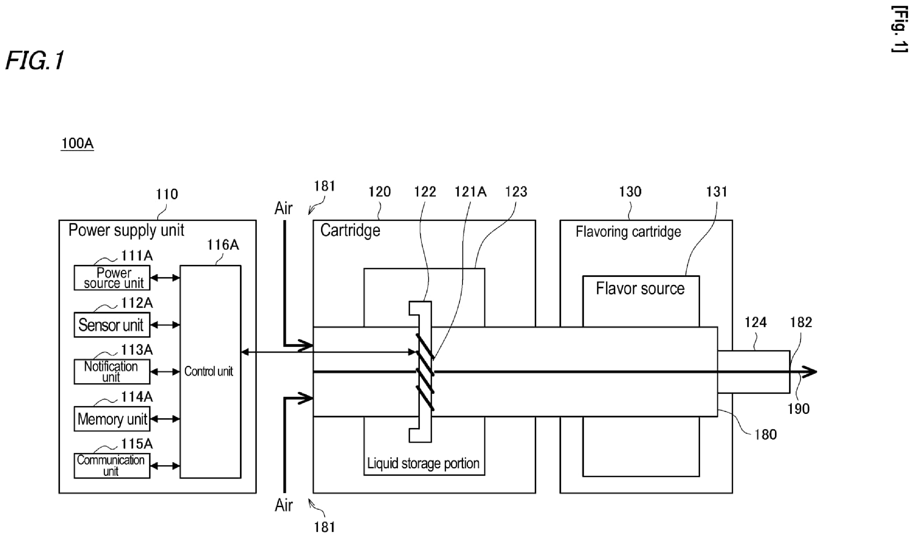

Fig. 1 is a schematic diagram schematically showing a first configuration example of an inhalation device. As shown in fig. 1, an inhalation device 100A according to this configuration example includes a power supply unit 110, a cartridge 120, and a flavoring cartridge 130. The power supply unit 110 comprises a power source unit 111A, a sensor unit 112A, a notification unit 113A, a memory unit 114A, a communication unit 115A, and a control unit 116A. The cartridge 120 includes a heating unit 121A, a liquid guiding portion 122, and a liquid storage portion 123. The flavoring cartridge 130 includes a flavor source 131 and a mouthpiece 124. An air flow path 180 is formed in the cartridge 120 and the flavoring cartridge 130.

The power source unit 111A stores electrical power. The power source unit 111A then supplies the electrical power to each component of the inhalation device 100A in accordance with control performed by the control unit 116A. Furthermore, the power source unit 111A is configured to be chargeable by means of power received from an external power source 1000. Here, the specific power is power that the inhalation device 100A is capable of receiving in terms of hardware, and may be, for example, direct current power having a predetermined voltage (for example, 5 to 20 [V]). The external power source 1000 may be an alternating current (AC) adapter configured to be capable of outputting the specific power, for example. Furthermore, the external power source 1000 is not limited to an AC adapter, and may be, for example, a portable charger (also referred to as a mobile battery), a PC (personal computer), a smartphone, or a tablet terminal, for example. The power source unit 111A may be configured, for example, by a rechargeable battery such as a lithium ion secondary battery. In the present embodiment, the power source unit 111A is mounted so that it can be inserted into and removed from the power supply unit 110 by the user.

The sensor unit 112A acquires various types of information relating to the inhalation device 100A. The sensor unit 112A is configured by, for example, a pressure sensor such as a capacitor microphone, a flow rate sensor or a temperature sensor, etc., and acquires values associated with inhalation by a user.

As an example, the sensor unit 112A may include a pressure sensor (also referred to as a "puff sensor") capable of detecting a change in pressure (also referred to hereinafter as "internal pressure") in the inhalation device 100A caused by inhalation by the user. As another example, the sensor unit 112A may include a flow sensor capable of detecting a flow rate caused by inhalation by the user (hereinafter simply referred to as "flow rate"). As another example, the sensor unit 112A may include a temperature sensor (also referred to as a "puff thermistor") capable of detecting the temperature of the heating unit 121A or the temperature around the heating unit 121A.

Furthermore, the sensor unit 112A may include a voltage sensor capable of detecting a terminal voltage of the power source unit 111A. The sensor unit 112A may further include a temperature sensor capable of detecting the temperature of the power source unit 111A.

Furthermore, the sensor unit 112A may comprise an input device, such as an operation button or a switch, for accepting input of information from the user. As an example, the sensor unit 112A may include an operation button serving as an input device that accepts mode change requests, which will be described later.

The notification unit 113A notifies the user of information. The notification unit 113A may, for example, be configured by a light-emitting device that emits light, a display device that displays images, a sound output device that outputs sound, or a vibration device that vibrates, etc.

The memory unit 114A stores various information (e.g., programs and data) for operation of the inhalation device 100A. The memory unit 114A may be configured by a non-volatile storage medium such as a flash memory, for example.

The communication unit 115A is a communication interface capable of performing communication conforming to any wired or wireless communication standard. Examples of communication standards that may be used include standards that employ Wi-Fi (registered trademark), Bluetooth (registered trademark), Bluetooth Low Energy (BLE) (registered trademark), Near-Field Communication (NFC), or Low Power Wide Area (LPWA), for example.

The control unit 116A functions as an arithmetic processing device and a control device, and controls overall operation within the inhalation device 100A in accordance with various programs stored in the memory unit 114A, etc. For example, the control unit 116A controls the supply of electricity (power supply) from the power source unit 111A to each component (for example, the heating unit 121A that will be described later), and controls charging of the power source unit 111A by means of power received from the external power source 1000. Note that the control unit 116A is realized by a central processing unit (CPU) or an electronic circuit such as a microprocessor, for example. As an example, the control unit 116A can be realized by an MCU 104 (MCU: Micro Controller portion), or the like, which will be described later.

The liquid storage portion 123 stores an aerosol source. The aerosol source is atomized to generate an aerosol. The aerosol source is a polyhydric alcohol such as glycerol or propylene glycol, or a liquid such as water, for example. The aerosol source may include a tobacco-derived or non-tobacco-derived flavor component. If the inhalation device 100A is a medical inhaler such as a nebulizer, the aerosol source may include a drug.

The liquid guiding portion 122 guides the aerosol source, which is a liquid stored in the liquid storage portion 123, from the liquid storage portion 123, and holds the aerosol source. The liquid guiding portion 122 is, for example, a wick formed by twisting either a fibrous material such as glass fibers or a porous material such as a porous ceramic. In this case, the aerosol source stored in the liquid storage portion 123 is guided by the capillary effect of the wick.

The heating unit 121A heats the aerosol source to atomize the aerosol source, thereby generating the aerosol, for example. The heating unit 121A is formed by any material, such as a metal or polyimide, in any shape, such as coiled, film-like or blade-like. In the example shown in fig. 1, the heating unit 121A is configured as a coil obtained by winding a heating resistor such as nichrome or stainless steel, and is wrapped around the liquid guiding portion 122. When the heating unit 121A generates heat, the aerosol source held in the liquid guiding portion 122 is heated and atomized, generating the aerosol. The heating unit 121A generates heat when supplied with electricity from the power source unit 111A.

As an example, the supply of electricity (power supply) to the heating unit 121A may be implemented when the sensor unit 112A has detected that the user has started inhaling and/or that predetermined information has been input. The supply of electricity to the heating unit 121A may then be stopped when the sensor unit 112A has detected that the user has finished inhaling and/or that predetermined information has been input.

Moreover, the heating unit 121A may be configured to generate an aerosol by means of vibration or induction heating. When the aerosol is generated by means of vibration, the inhalation device 100A comprises a vibration unit as the heating unit 121A. For example, the vibration unit is configured by a plate-shaped member comprising a piezoelectric ceramic functioning as an ultrasonic vibrator. When the vibration unit vibrates, the aerosol source which has been guided to a surface of the vibration unit by means of the liquid guiding portion 122 is then atomized by means of ultrasound generated as the vibration unit vibrates, thereby generating the aerosol.

Furthermore, when the aerosol is generated by means of induction heating, the inhalation device 100A comprises a susceptor and an electromagnetic induction source as the heating unit 121A. The susceptor is made of an electrically conductive material, such as a metal, and generates heat by means of electromagnetic induction. Furthermore, the susceptor is disposed adjacent to the liquid guiding portion 122. As an example, the susceptor is formed by a metallic conducting wire and is wound around the liquid guiding portion 122. The electromagnetic induction source causes the susceptor to generate heat by electromagnetic induction. The electromagnetic induction source is formed by a coiled conducting wire, for example, and generates a magnetic field when supplied with an AC current from the power source unit 111A. When a magnetic field is generated, eddy currents are generated in the susceptor, and Joule heat is generated. The aerosol source held in the liquid guiding portion 122 is then heated by this Joule heat and atomized, generating the aerosol.

The flavor source 131 is a component for imparting a flavor component to the aerosol. The flavor source 131 includes tobacco-derived or non-tobacco-derived flavor components. The flavor source 131 may be, for example, a tobacco-derived substance such as cut tobacco, or a processed product obtained by molding a tobacco raw material into a granular form, a sheet form, or a powder form. Furthermore, the flavor source 131 may also include non-tobacco-derived materials made from plants other than tobacco (e.g., mint and herbs, etc.). As one example, the flavor source 131 may contain a flavoring component such as menthol. Furthermore, the flavor source 131 may be a stick-type member. When the inhalation device 100A is a medical inhaler, the flavor source 131 may contain a drug to be inhaled by a patient. It should be noted that the aerosol source 131 is not limited to a solid, and may equally be a liquid containing a flavor component, such as a polyhydric alcohol such as glycerol or propylene glycol, or water, for example. Furthermore, the flavor source 131 may be arranged inside a container such as a capsule.

The air flow path 180 is a flow path for air to be inhaled by the user. The air flow path 180 has a tubular structure with an air inflow hole 181, which is an inlet for air into the air flow path 180, and an air outflow hole 182, which is an outlet for air from the air flow path 180, at the two ends thereof. Partway along the air flow path 180, the liquid guiding portion 122 is disposed on the upstream side (the side closer to the air inflow hole 181), and the flavor source 131 is disposed on the downstream side (the side closer to the air outflow hole 182). Air that flows in through the air inflow hole 181 as the user inhales is mixed with the aerosol generated by the heating unit 121A and is transported through the flavor source 131 to the air outflow hole 182, as shown by the arrow 190. When the mixed fluid of aerosol and air passes through the flavor source 131, the flavor component contained in the flavor source 131 is added to the aerosol.

The mouthpiece 124 is a member that is held in the user's mouth during inhalation. The air outflow hole 182 is disposed in the mouthpiece 124. The user holds the mouthpiece 124 in their mouth and inhales, making it possible to draw the mixed fluid of aerosol and air into the oral cavity.

A configuration example of the inhalation device 100A has been described above. The inhalation device 100A is, of course, not limited to the configuration described above, and various configurations, such as those illustrated below by way of example, may be adopted.

As an example, the inhalation device 100A need not include the flavoring cartridge 130. In this case, the cartridge 120 is provided with the mouthpiece 124.

As another example, the inhalation device 100A may further include a flavor source heating unit (not depicted) for heating the flavor source 131. The flavor source heating unit is configured in a film shape and is disposed so as to cover the outer periphery of the flavor source 131, for example. The flavor source heating unit then generates heat when supplied with power from the power source unit 111A, heating the flavor source 131 from the outer periphery thereof. It should be noted that the flavor source heating unit may also be configured with a blade-like form, piercing the flavor source 131 to heat the flavor source 131 from the inside, for example. Furthermore, the flavor source heating unit may be configured to heat the flavor source 131 by means of vibration or induction heating. Providing such a flavor source heating unit makes it possible to increase the temperature of the flavor source 131 and to increase the amount of flavor component added to the aerosol, as compared to a case in which the flavor source heating unit is not provided.

Furthermore, as another example, the inhalation device 100A may include a plurality of types of aerosol sources. A plurality of types of aerosol generated from the plurality of types of aerosol sources may be mixed within the air flow path 180 to cause a chemical reaction, thereby generating yet more other types of aerosol.

Furthermore, the means for atomizing the aerosol source is not limited to heating by the heating unit 121A. For example, the means for atomizing the aerosol source may be vibration atomization or induction heating.

### <1-2. Second configuration example of inhalation device>

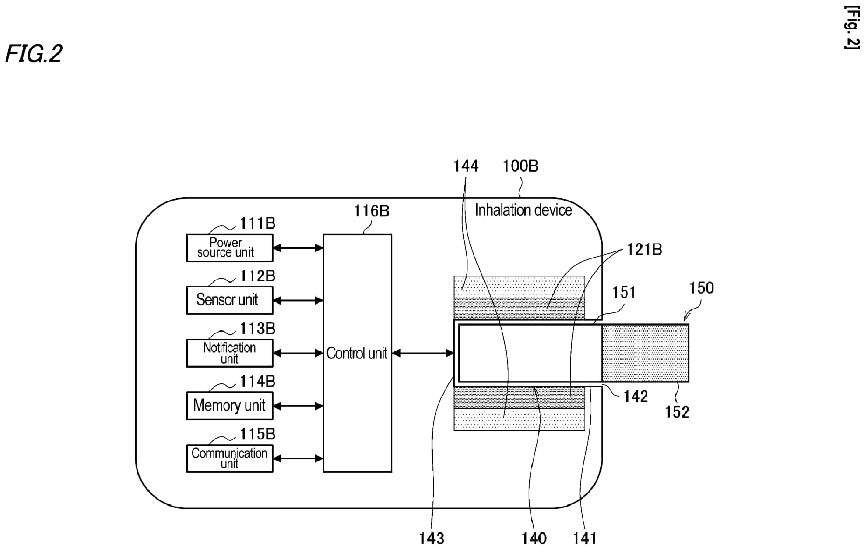

Fig. 2 is a schematic diagram schematically showing a second configuration example of an inhalation device. As shown in fig. 2, an inhalation device 100B according to this configuration example comprises a power source unit 111B, a sensor unit 112B, a notification unit 113B, a memory unit 114B, a communication unit 115B, a control unit 116B, a heating unit 121B, an accommodating portion 140, and a heat insulating portion 144.

The power source unit 111B, sensor unit 112B, notification unit 113B, memory unit 114B, communication unit 115B, and control unit 116B are each substantially the same as the corresponding component included in the inhalation device 100A described above. Moreover, in the case of the inhalation device 100B shown in fig. 2, the inhalation device 100B itself may also be referred to as the power supply unit. In this embodiment, the power source unit 111B is mounted so that it can be inserted into and removed from the inhalation device 100B by the user.

The accommodating portion 140 has an internal space 141, and holds a stick-type substrate 150 while accommodating a portion of the stick-type substrate 150 in the internal space 141. The accommodating portion 140 has an opening 142 allowing the internal space 141 to communicate with the outside, and accommodates the stick-type substrate 150 which has been inserted into the internal space 141 from the opening 142. For example, the accommodating portion 140 is a cylindrical body comprising the opening 142 and a bottom portion 143 serving as a bottom surface, and defines a columnar internal space 141. An air flow path for supplying air to the internal space 141 is connected to the accommodating portion 140. An air inflow hole, which is an inlet for air into the air flow path, is disposed in a side surface of the inhalation device 100, for example. An air outflow hole, which is an outlet for air from the air flow path to the internal space 141, is disposed in the bottom portion 143, for example.

The stick-type substrate 150 comprises a substrate portion 151 and a mouthpiece portion 152. The substrate portion 151 contains an aerosol source. The aerosol source includes a tobacco-derived or non-tobacco-derived flavor component. If the inhalation device 100B is a medical inhaler such as a nebulizer, the aerosol source may include a drug. The aerosol source may, for example, be a liquid such as water or a polyhydric alcohol, for example glycerol or propylene glycol, containing the tobacco-derived or non-tobacco-derived flavor component, or may be a solid including the tobacco-derived or non-tobacco-derived flavor component. In a state in which the stick-type substrate 150 is held in the accommodating portion 140, at least part of the substrate portion 151 is accommodated in the internal space 141, and at least part of the mouthpiece portion 152 protrudes from the opening 142. Then, when the user holds the mouthpiece portion 152 protruding from the opening 142 in their mouth and inhales, air flows into the internal space 141 via the air flow path, which is not illustrated on the drawings, and reaches the inside of the user's mouth together with the aerosol generated from the substrate portion 151.

In the example shown in fig. 2, the heating unit 121B is configured as a film heater obtained by laying out an electrically conductive track made of a heat generating resistor having a correlation between electrical resistance and temperature, and is arranged to cover the outer periphery of the accommodating portion 140. Then, when the heating unit 121B generates heat, the substrate portion 151 of the stick-type substrate 150 is heated from the outer periphery, generating the aerosol. It should be noted that a heating resistor the same as that of the heating unit 121A described above may be used as the heating resistor of the heating unit 121B.

The heat insulating portion 144 prevents heat transfer from the heating unit 121B to other components. For example, the heat insulating portion 144 is configured from a vacuum heat insulating material or an aerogel heat insulating material, or the like.

A configuration example of the inhalation device 100B has been described above. The inhalation device 100B is, of course, not limited to the configuration described above, and various configurations, such as those illustrated below by way of example, may be adopted.

As one example, the heating unit 121B may be configured with a blade-like form and may be arranged so as to protrude into the internal space 141 from the bottom portion 143 of the accommodating portion 140. In that case, the blade-like heating unit 121B is inserted into the substrate portion 151 of the stick-type substrate 150 and heats the substrate portion 151 of the stick-type substrate 150 from the inside. As another example, the heating unit 121B may be arranged so as to cover the bottom portion 143 of the accommodating portion 140. Furthermore, the heating unit 121B may be configured from a combination of two or more from among a first heating unit covering the outer circumference of the accommodating portion 140, a blade-like second heating unit, and a third heating unit covering the bottom portion 143 of the accommodating portion 140.

As another example, the accommodating portion 140 may include an opening and closing mechanism such as a hinge for opening and closing part of an outer casing that forms the internal space 141. Then, by opening and closing the outer casing, the accommodating portion 140 may accommodate and grip the stick-type substrate 150 that has been inserted into the internal space 141. In this case, the heating unit 121B may be provided on the gripping part of the accommodating portion 140, and may heat the stick-type substrate 150 while pressing the same.

Furthermore, the means for atomizing the aerosol source is not limited to heating by the heating unit 121B. For example, the means for atomizing the aerosol source may be induction heating. In that case, the inhalation device 100B comprises at least an electromagnetic induction source such as a coil for generating a magnetic field, instead of the heating unit 121B. A susceptor which generates heat by means of induction heating may be provided in the inhalation device 100B, or may be contained in the stick-type substrate 150.

Furthermore, the inhalation device 100B may additionally include the heating unit 121A, the liquid guiding portion 122, the liquid storage portion 123, and the air flow path 180 according to the first configuration example, and the air flow path 180 may supply air to the internal space 141. In this case, the mixed fluid of the aerosol generated by the heating unit 121A and air flows into the internal space 141 and is further mixed with the aerosol generated by the heating unit 121B, and reaches the oral cavity of the user.

Note that, hereinafter, the inhalation device 100A and the inhalation device 100B described above will also be referred to, without distinction, as the "inhalation device 100". Similarly, the power source unit 111A and the power source unit 111B may be referred to as the "power source unit 111", the sensor unit 112A and the sensor unit 112B may be referred to as the "sensor unit 112", the notification unit 113A and the notification unit 113B may be referred to as the "notification unit 113", the memory unit 114A and the memory unit 114B may be referred to as the "memory unit 114", the communication unit 115A and the communication unit 115B may be referred to as the "communication unit 115", the control unit 116A and the control unit 116B may be referred to as the "control unit 116", and the heating unit 121A and the heating unit 121B may be referred to as the "heating unit 121".

### [2. Configuration example of inhalation device]

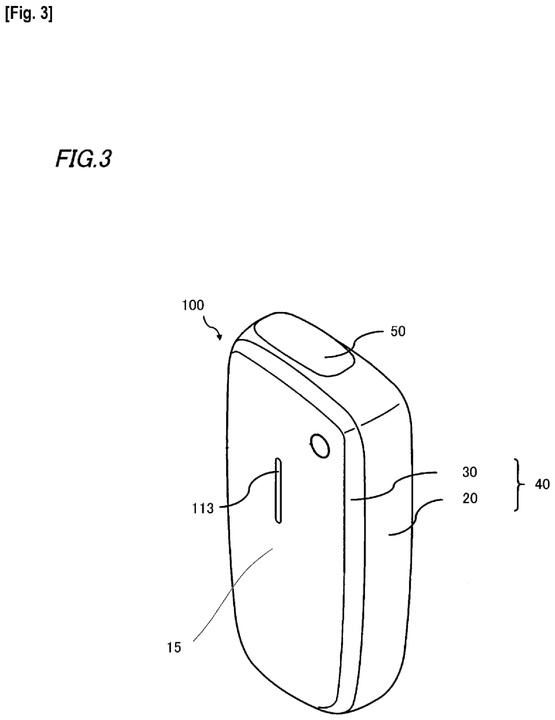

Fig. 3 is an overall oblique view of the inhalation device 100 according to the present embodiment. As shown in fig. 3, the inhalation device 100 comprises a case 20 and a shutter 50. The case 20 accommodates the power supply unit 110 of the inhalation device 100.

Further, a panel 30 is attached to the case 20. The panel 30 is attached to the case 20 to configure an outermost housing 40 of the inhalation device 100. Furthermore, the inhalation device 100 comprises the panel 30, so that even if the power supply unit 110 generates heat, the heat released to the outside can be reduced. That is to say, the panel 30 functions to provide insulation from heat generated from the heating unit of the power supply unit 110. Furthermore, the panel 30 is formed so that the surface is a substantially curved surface. When the panel 30 is attached to the case 20, the panel 30 then defines an internal space together with the surface of the case 20.

When a user presses on the surface of the panel 30 with their fingertip, the panel 30 deforms to form an indentation toward the case 20. As a result of such deformation of the panel 30, a protrusion provided on the panel 30 comes into contact with an operation button provided (not depicted) on the surface of the case 20, and the operation button is thereby depressed. That is, the part of the surface of the panel 30 which is pressed in by the fingertip forms the operation portion 15.

### [3. Example of operating modes of the inhalation device]

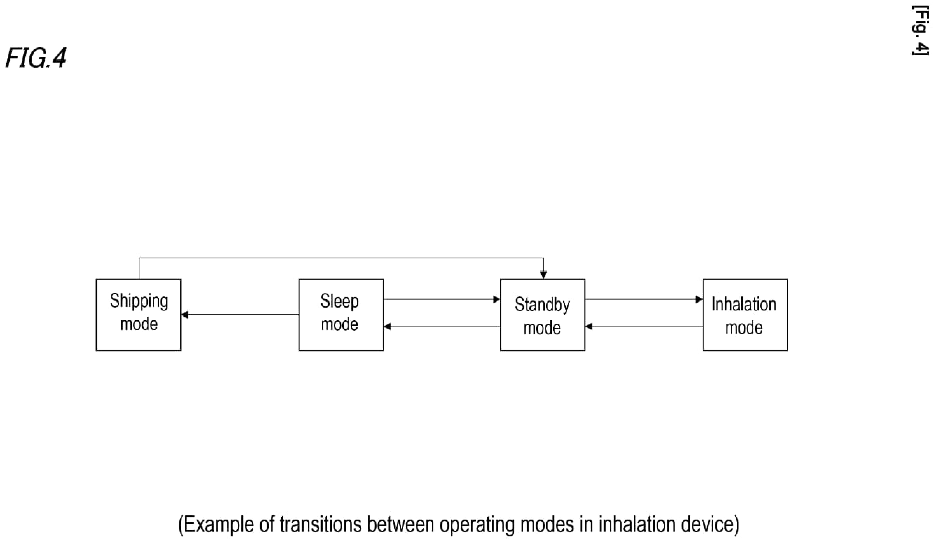

As shown in fig. 4, the control unit 116 has a plurality of operating modes for operating the inhalation device 100. In this example, the control unit 116 has, as operating modes for operating the inhalation device 100, an inhalation mode, a standby mode, a sleep mode, and a shipping mode. The control unit 116 controls the discharge of power from the power source unit 111 to cause the inhalation device 100 to operate in the inhalation mode, the standby mode, the sleep mode, and the shipping mode.

The inhalation mode is a mode in which heating control of the heating unit 121 is carried out. The control unit 116 carries out heating control of the heating unit 121 when the operating mode is switched to the inhalation mode.

The standby mode is a mode in which almost all functions are active except for heating control of the heating unit 121. The control unit 116 switches the operating mode from the standby mode to the inhalation mode when a predetermined operation is performed, such as an inhalation action by the user. Also, the control unit 116 switches the operating mode from the inhalation mode to the standby mode if, when in the inhalation mode, the heating control of the heating unit 121 ends, such as the energization time of the heating unit 121 or the number of inhalations by the user reaching an upper limit.

The sleep mode is a mode in which the inhalation device 100 consumes less power than the standby mode, and is a mode that can transition directly to the standby mode. Therefore, by transitioning the inhalation device 100 to the sleep mode, the control unit 116 can reduce the power consumption of the power source unit 111 while maintaining a state in which it is possible to return to other modes as required. When the inhalation device 100 is operating in the sleep mode, the sensor unit 112 can detect opening of the shutter 50, connection of a USB cable, operation of the operation portion 15, and so on, and it is possible to monitor the remaining battery charge, but the heating unit 121 cannot be operated immediately. The control unit 116 switches the operating mode from the sleep mode to the standby mode when a predetermined operation is performed, such as operation of the operation portion 15 by the user. Also, the control unit 116 switches the operating mode from the standby mode to the sleep mode when a predetermined condition is met, such as when a state with no operation lasts for a predetermined time in the standby mode.

The shipping mode is a mode in which the inhalation device 100 consumes less power than the sleep mode, the main power supply path from the power source unit 111 is interrupted, and the quiescent current is significantly reduced to minimize power consumption of the power source unit 111. In the shipping mode, discharge from the power source unit 111 is limited to the minimum necessary, such as only for the part of the sensor unit 112 that detects connection of a USB cable, etc., and the part that detects that the operation portion 15 has been operated, and only for the part of the control unit 116 there changes the mode of operation of the inhalation device 100 on the basis of the function of the sensor unit 112 for detecting connection of a USB cable, etc., and the function for detecting that the operation portion 15 has been operated, for example. The shipping mode is used, for example, during transportation after manufacturing and shipping of the inhalation device 100, or during long-term storage in a warehouse, or the like, to transport and store the inhalation device 100 with reduced power consumption of the power source unit 111. In this example, the shipping mode is also used when replacing the power source unit 111, as will be described later. The control unit 116 switches the operating mode from the shipping mode to the standby mode when a predetermined operation is performed, such as operation of the operation portion 15 by the user or when an external power source 1000 is connected to the inhalation device 100. Note that the control unit 116 may switch the operating mode from the shipping mode to the sleep mode when a predetermined operation is performed, such as operation of the operation portion 15 by the user or when an external power source 1000 is connected to the inhalation device 100.

When in the shipping mode, the control unit 116 transitions to the standby mode when a predetermined operation is performed by the user. Also, when in the sleep mode, the control unit 116 transitions to the standby mode when a predetermined operation is performed by the user, and transitions to the shipping mode when a predetermined operation is performed by the user (an operation different from the operation that transitions to the standby mode). Also, when in the standby mode, the control unit 116 transitions to the inhalation mode when a predetermined operation is performed by the user, and transitions to the sleep mode when a predetermined operation is performed by the user (an operation different from the operation which transitions to the inhalation mode). In addition, when in the inhalation mode, the mode is transitioned to the standby mode when a predetermined operation by the user is performed or when a predetermined condition is satisfied. Note that when the control unit 116 is in the standby mode, the mode may be transitioned to the shipping mode by a predetermined operation by the user. In this case, the predetermined operation by the user for transitioning from the sleep mode to the shipping mode and the predetermined operation by the user for transitioning from the standby mode to the shipping mode may be the same operation.

### [4. Insertion/removal of power source unit]

The power source unit 111 is mounted so that it can be inserted into and removed from the power supply unit 110 by the user. It should be noted that in the inhalation device 100, the direction in which the flavor source 131 or the stick-type substrate 150 is inserted/removed relative to the inhalation device 100 is the vertical direction, and the side of the inhalation device 100 on which the flavor source 131 or the stick-type substrate 150 is inserted is defined as the upper side. In other words, the flavor source 131 or the stick-type substrate 150 is inserted into the inhalation device 100 from above. Furthermore, a direction orthogonal to the vertical direction may be referred to as a transverse direction, and the face oriented in the transverse direction may be referred to as a side face.

Note that although first to third examples are described below as examples of insertion and removal aspects of the power source unit 111, the power source unit 111 can be inserted into and removed from the power supply unit 110 by the user by aspects other than the first to third examples.

### <4-1. First example of mode of insertion/removal of power source unit>

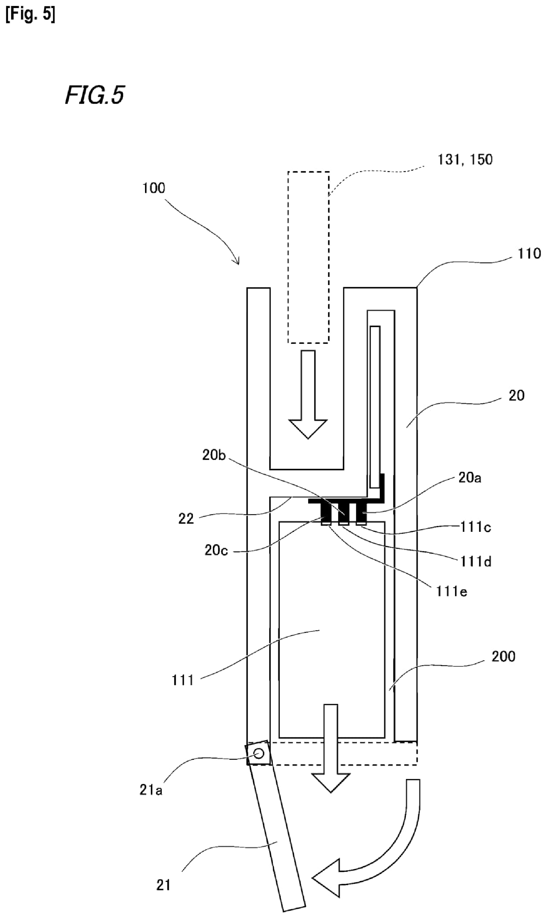

As shown in fig. 5, the case 20 has a bottom wall portion 21 constituting at least a part of the bottom surface, and the bottom wall portion 21 is provided in the case 20 so that it can be opened and closed about a transversally extending hinge portion 21a.

A power source accommodating portion 200 that can accommodate the power source unit 111 is formed in a lower region of the case 20. When the bottom wall portion 21 is opened, the power source accommodating portion 200 communicates with the outside of the case 20, allowing the power source unit 111 to be inserted into the power source accommodating portion 200 from the bottom of the case 20. That is, the bottom wall portion 21 acts as an opening and closing member for the power source accommodating portion 200.

The power source unit 111 comprises a positive electrode terminal 111c and a negative electrode terminal 111d, and a temperature terminal 111e through which an electrical signal relating to the temperature of the power source unit 111 flows. The case 20 is provided with a positive terminal connection portion 20a for electrically connecting with the positive electrode terminal 111c of the power source unit 111, a negative terminal connection portion 20b for electrically connecting with the negative electrode terminal 111d of the power source unit 111, and a temperature terminal connection portion 20c for electrically connecting with the temperature terminal 111e of the power source unit 111. It should be noted that the power source unit 111 is provided with a battery temperature sensor, which is not shown in the drawings. The battery temperature sensor is, for example, a thermistor. The battery temperature sensor includes a resistor, and outputs a detection signal indicating the electrical resistance value of this resistor as a measurement signal indicating a parameter relating to the temperature of the power source unit 111. Furthermore, the battery temperature sensor may equally output a measurement signal directly indicating the battery temperature. Then, the detection signal indicating a parameter related to the temperature of the power source unit 111 flows to the temperature terminal 111e.

When accommodated in the power source accommodating portion 200, the power source unit 111 is held by the bottom wall portion 21 and a top wall portion 22 of the power source accommodating portion 200. The power source unit 111 is held in the power source accommodating portion 200 with the positive electrode terminal 111c in electrical connection with the positive terminal connection portion 20a, the negative electrode terminal 111d in electrical connection with the negative terminal connection portion 20b, and the temperature terminal 111e in electrical connection with the temperature terminal connection portion 20c.

In this example, the positive electrode terminal 111c, the negative electrode terminal 111d and the temperature terminal 111e are all provided on an upper surface of the power source unit 111, and the positive terminal connection portion 20a, the negative terminal connection portion 20b, and the temperature terminal connection portion 20c are provided in the top wall portion 22 of the power source accommodating portion 200.

When the bottom wall portion 21 is opened while the power source unit 111 is accommodated in the power source accommodating portion 200, the power source accommodating portion 200 communicates with the outside of the case 20, and the power source unit 111 can be removed from the power source accommodating portion 200.

In this way, the power source unit 111 is mounted so that it can be inserted into and removed from the power supply unit 110 by the user.

### <4-2. Second example of mode of insertion/removal of power source unit>

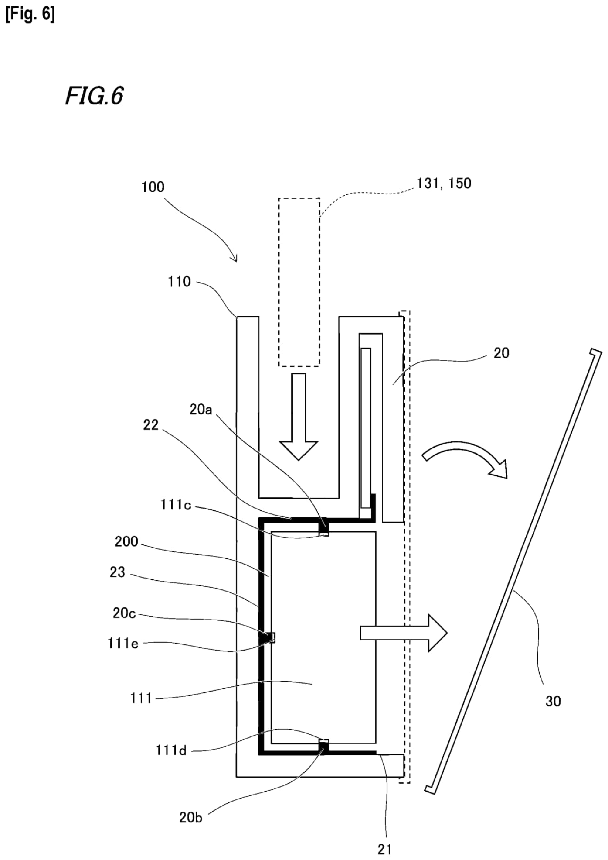

As shown in fig. 6, the power source accommodating portion 200, which can accommodate the power source unit 111, is formed in the lower region of the case 20. When the previously described panel 30 is removed from the case 20, the power source accommodating portion 200 communicates with the outside of the case 20, allowing the power source unit 111 to be inserted into the power source accommodating portion 200 from the transverse direction of the case 20. That is, the panel 30 also acts as an opening and closing member for the power source accommodating portion 200.

The power source unit 111 comprises a positive electrode terminal 111c and a negative electrode terminal 111d, and a temperature terminal 111e through which an electrical signal relating to the temperature of the power source unit 111 flows. The case 20 is provided with a positive terminal connection portion 20a for electrically connecting with the positive electrode terminal 111c of the power source unit 111, a negative terminal connection portion 20b for electrically connecting with the negative electrode terminal 111d of the power source unit 111, and a temperature terminal connection portion 20c for electrically connecting with the temperature terminal 111e of the power source unit 111.

When accommodated in the power source accommodating portion 200, the power source unit 111 is held in the power source accommodating portion 200. The power source unit 111 is held in the power source accommodating portion 200 with the positive electrode terminal 111c in electrical connection with the positive terminal connection portion 20a, the negative electrode terminal 111d in electrical connection with the negative terminal connection portion 20b, and the temperature terminal 111e in electrical connection with the temperature terminal connection portion 20c.

In the present example, the positive electrode terminal 111c is provided on the upper surface of the power source unit 111, the negative electrode terminal 111d on the lower surface of the power source unit 111, and the temperature terminal 111e on the side of the power source unit 111, and the positive terminal connection portion 20a is provided on the upper wall 22 of the power source accommodating portion 200, the negative terminal connection portion 20b on the bottom wall portion 21 of the power source accommodating portion 200 and the temperature terminal connection portion 20c on a side wall portion 23 of the power source accommodating portion 200.

When the panel 30 is removed from the case 20 while the power source unit 111 is accommodated in the power source accommodating portion 200, the power source accommodating portion 200 communicates with the outside of the case 20, and the power source unit 111 can be removed from the power source accommodating portion 200.

In this way, the power source unit 111 is mounted so that it can be inserted into and removed from the power supply unit 110 by the user.

### <4-3. Third example of mode of insertion/removal of power source unit>

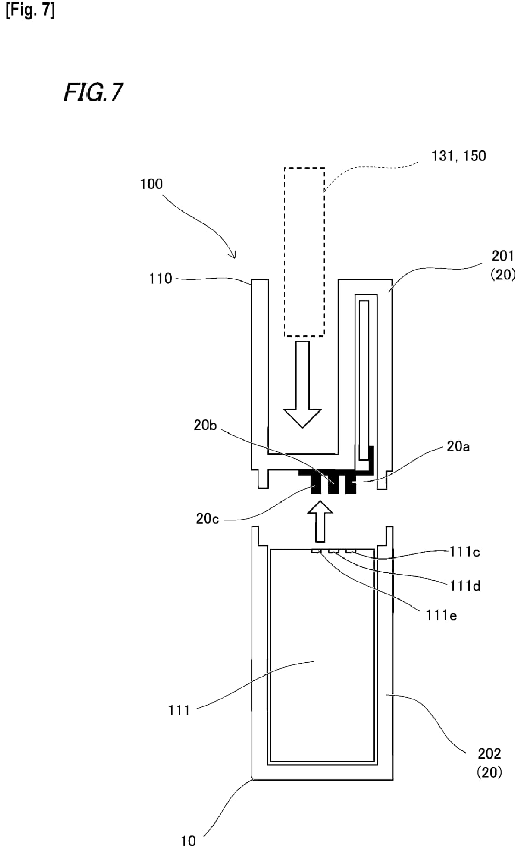

As shown in fig. 7, the case 20 comprises an upper case 201 constituting the outer case of the upper region of the inhalation device 100, and a lower case 202 constituting the outer case of the lower region of the inhalation device 100.

The lower case 202 is open at an upper face and internally accommodates the power source unit 111. In this way, in the present example, the power source unit 111 and the lower case 202 constitute a modularized battery pack 10.

The upper surface of the power source unit 111 is provided with the positive electrode terminal 111c and the negative electrode terminal 111d, and the temperature terminal 111e through which an electrical signal relating to the temperature of the power source unit 111 flows. At the lower end of the upper case 201, the positive terminal connection portion 20a for electrically connecting with the positive electrode terminal 111c of the power source unit 111, the negative terminal connection portion 20b for electrically connecting with the negative electrode terminal 111d of the power source unit 111, and the temperature terminal connection portion 20c for electrically connecting with the temperature terminal 111e of the power source unit 111 are provided.

The battery pack 10, in which the power source unit 111 and the lower case 202 are modularized, is mounted in the upper case 201 from below. For example, both the upper case 201 and the lower case 202 may have a substantially cylindrical shape extending vertically, and threaded grooves may have been machined in the outer circumferential surface of one of the lower end of the upper case 201 and the upper end of the lower case 202, and in the inner circumferential surface of the other of the lower end of the upper case 201 and the upper end of the lower case 202, and the modularized battery pack 10 comprising the power source unit 111 and the lower case 202 may be attached to the upper case 201 by screwing together the lower end of the upper case 201 and the upper end of the lower case 202. Also, for example, a magnet may be provided at one of the lower end of the upper case 201 and the upper end of the lower case 202, and the other of the lower end of the upper case 201 and the upper end of the lower case 202 may be formed of ferromagnetic material, and the modularized battery pack 10 comprising the power source unit 111 and the lower case 202 may be attached to the upper case 201 by the lower end of the upper case 201 and the upper end of the lower case 202 being attracted to each other by magnetic force. Also, for example, the lower case 202 may have a locking portion such as a claw, and the modularized battery pack 10 comprising the power source unit 111 and the lower case 202 may be attach to the upper case 201 by locking the locking portion to the upper case 201.

With the modularized battery pack 10, comprising the power source unit 111 and the lower case 202, attached to the upper case 201, the power source unit 111 is held with the positive electrode terminal 111c in electrical connection with the positive terminal connection portion 20a, the negative electrode terminal 111d in electrical connection with the negative terminal connection portion 20b, and the temperature terminal 111e in electrical connection with the temperature terminal connection portion 20c.

In this way, the modularized battery pack 10, comprising the power source unit 111 and the lower case 202, is detachably mounted onto the upper case 201, and the power source unit 111 is mounted so that it can be inserted into and removed from the power supply unit 110 by the user.

### [5. Control flow when power source unit is replaced]

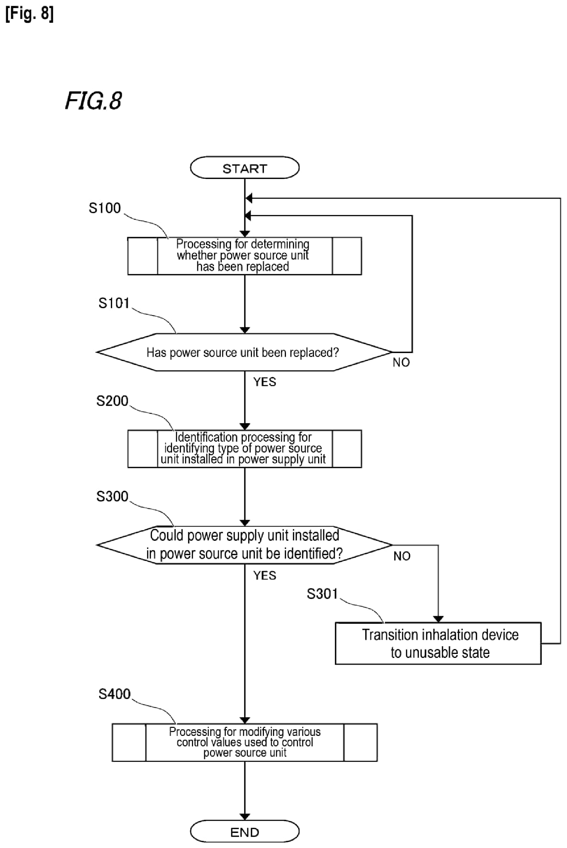

Next, the control flow when the power source unit 111 installed in the power supply unit 110 is replaced will be described with reference to fig. 8.

The control unit 116 first performs processing for determining whether the power source unit 111 mounted in the power supply unit 110 has been replaced (step S100). Details of the processing for determining whether the power source unit 111 mounted in the power supply unit 110 has been replaced will be described later.

Upon completion of step S100, the control unit 116 proceeds to step S101 and determines whether the power source unit 111 mounted in the power supply unit 110 was determined to have been replaced at step S101.

At step S101, the control unit 116 returns to step S100 if at step S101 it was determined that the power source unit 111 mounted in the power supply unit 110 has not been replaced (step S101: NO).

The control unit 116 proceeds to step S200 when it is determined at step S101 that the power source unit 111 mounted in the power supply unit 110 has been replaced (step S101: YES).

The control unit 116 performs processing for identifying the type of power source unit 111 mounted in the power supply unit 110 in step S200. Details of the flow of the processing for identifying the type of power source unit 111 mounted in the power supply unit 110 will be described later. The routine then moves to step S300.

In this way, the processing for identifying the type of power source unit 111 mounted in the power supply unit 110 is carried out when it has been determined that the power source unit 111 mounted in the power supply unit 110 has been replaced, and the processing for identifying the type of power source unit 111 can therefore be carried out at the necessary and appropriate time.

The control unit 116 determines whether, at step S300, the type of power source unit 111 mounted in the power supply unit 110 could be identified in step S200.

When the control unit 116 could not identify the type of power source unit 111 mounted on the power supply unit 110 in step S200 (step S300: NO), the process moves to step S301. The control unit 116 may not be able to identify the type of power source unit 111 mounted in the power supply unit 110 at step S200 if, for example, a power source unit that is not compatible with the inhalation device 100 is mounted in the power supply unit 110, or if an identification unit fails to detect the type of power source unit 111 mounted in the power supply unit 110 in the identification flow.

At step S301, the control unit 116 transitions the inhalation device 100 to an unusable state and returns to step S100. For example, the control unit 116 prevents transition to the standby mode even if the user has performed an operation to transition to the standby mode. Also, for example, the control unit 116 prevents the supply of power to the heating unit 121 even if an inhalation operation by the user is detected.

This improves safety as the inhalation device 100 can be disabled if a power source that is not compatible with the inhalation device 100 is mounted in the power supply unit 110, or if a power source compatible with the inhalation device 100 is not correctly mounted in the power supply unit 110, and so on.

Meanwhile, if the control unit 116 was able to identify the type of power source unit 111 installed in the power supply unit 110 at step S200 (step S300: YES), the flow proceeds to step S400 and the control unit performs processing for modifying various control values used when controlling the power source unit 111, in accordance with the type of power source unit 111 installed in the power supply unit 110, and then ends the series of controls.

### [6. Determining whether power source unit has been replaced]

Next, first to third examples will be described as examples of the modes for determining whether the power source unit 111 has been replaced in step S100, previously described. Note that whether the power source unit 111 has been replaced may be determined by modes other than the first to third examples.

### <6-1. First example of mode for determining whether power source unit has been replaced>

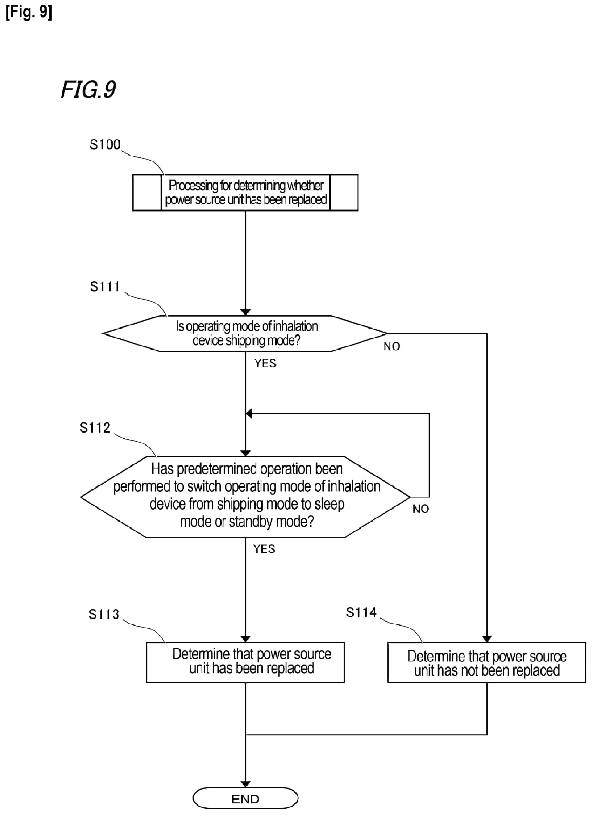

Fig. 9 is a flowchart showing a first example of a mode for determining whether the power source unit 111 has been replaced.

In this example, when replacing the power source unit 111, the mode in which the user performs a predetermined operation to operate the inhalation device 100 must be switched to the shipping mode, taking into consideration safety aspects, etc. The predetermined operation to switch the operating mode of the inhalation device 100 to the shipping mode is, for example, an operation for pressing and holding the operation portion 15 continuously for more than a predetermined time period (for example, 5 seconds). Also, for example, the power supply unit 110 of the inhalation device 100 can communicate with a communication terminal such as a smartphone, tablet, or personal computer (PC), and the communication terminal and the power supply unit 110 of the inhalation device 100 can cooperate via an application installed on the communication terminal, and the predetermined operation to switch the operating mode of the inhalation device 100 to the shipping mode may be performed by using the application installed on the communication terminal to switch the operating mode of the inhalation device 100 to the shipping mode.

The control unit 116 first of all determines whether or not the operating mode of the inhalation device 100 is the shipping mode (step S111). When the operation mode for operating the inhalation device 100 is not the shipping mode (step S111: NO), the control portion 116 proceeds to step S114, determines that the power source unit 111 has not been replaced, and ends the determination of whether the power source unit 111 has been replaced in step S100.

Then, the control unit 116 proceeds to step S112 if the operating mode of the inhalation device 100 is the shipping mode (step S111: YES).

After performing the predetermined operation to switch the operating mode of the inhalation device 100 to the shipping mode, the user replaces the power source unit 111 by removing the power source unit 111 from the inhalation device 100 and attaching a new power source unit 111 to the inhalation device 100.

Then, when replacement of the power source unit 111 has been completed by attaching the new power source unit 111 to the inhalation device 100, the user performs a predetermined operation to switch the operating mode of the inhalation device 100 from the shipping mode to the sleep mode or the standby mode. The predetermined operation for switching the operating mode of the inhalation device 100 from the shipping mode to the sleep mode or the standby mode is, for example, the operation of connecting an external power source 1000 to the external connection terminal of the inhalation device 100.

At step S112, the control unit 116 determines whether the predetermined operation has been performed to switch the operating mode of the inhalation device 100 from the shipping mode to the sleep mode or the standby mode. The control unit 116 is in a standby state until the predetermined operation for switching the operating mode of the inhalation device 100 from the shipping mode to the sleep mode or the standby mode (loop of step S112: NO) is performed.

When the predetermined operation to switch the operating mode of the inhalation device 100 from the shipping mode to the sleep mode or the standby mode (step S112: YES) has been performed, the control unit 116 proceeds to step S113, determines that the power source unit 111 has been replaced, and ends the determination, at step S100, of whether the power source unit 111 has been replaced.

This makes it possible to determine whether or not the power source unit 111 has been replaced by means of simple control.

### <6-2. Second example of mode for determining whether power source unit has been replaced>

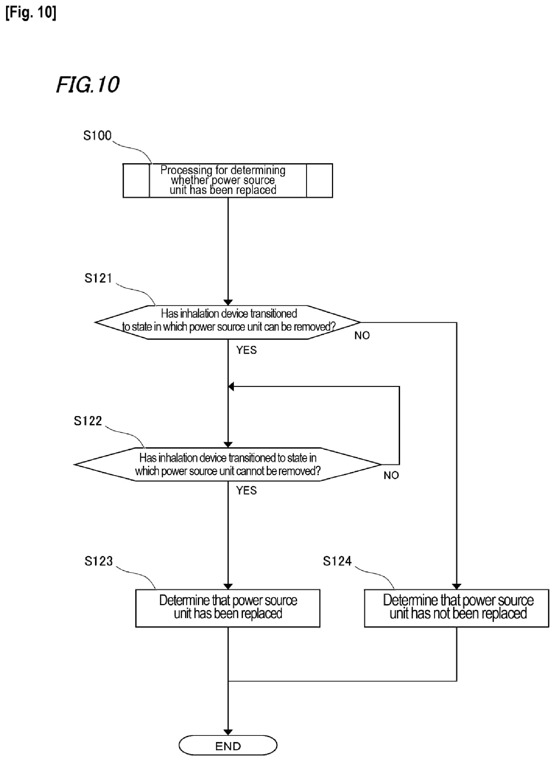

Fig. 10 is a flowchart showing a second example of a mode for determining whether the power source unit 111 has been replaced.

First, the control unit 116 determines whether the inhalation device 100 has transitioned to a state in which the power source unit 111 can be removed (step S121). For example, in "First example of mode of insertion/removal of power source unit" described above, whether or not the inhalation device 100 has transitioned to the state in which the power source unit 111 can be removed is determined as follows: if the bottom wall portion 21, which can be opened and closed about the hinge portion 21a, is in the open state and the power source accommodating portion 200 is in the open state, it is determined that the inhalation device 100 has transitioned to a state in which the power source unit 111 can be removed (step S121: YES); if the bottom wall portion 21, which can be opened and closed about the hinge portion 21a, is not in an open state and the power source accommodating portion 200 is not in an open state, it is determined that the inhalation device 100 has not transitioned to a state in which the power source unit 111 can be removed (step S121: NO). Also, for example, in "Second example of mode of insertion/removal of power source unit" described above, whether or not the inhalation device 100 has transitioned to the state in which the power source unit 111 can be removed is determined as follows: if the panel 30 is removed from the case 20 and the power source accommodating portion 200 is in an open state, it is determined that the inhalation device 100 has transitioned to a state in which the power source unit 111 can be removed (step S121: YES); If the panel 30 is not removed from the case 20 and the power source accommodating portion 200 is not in an open state, it is determined that the inhalation device 100 has not transitioned to a state in which the power source unit 111 can be removed (step S121: NO). Also, for example, in "Third example of mode of insertion/removal of power source unit" described above, whether or not the inhalation device 100 has transitioned to the state in which the power source unit 111 can be removed is determined as follows: if the modularized battery pack 10 comprising the power source unit 111 and the lower case 202 is removed from the upper case 201, it is determined that the inhalation device 100 has transitioned to a state in which the power source unit 111 can be removed (step S121: YES); if the modularized battery pack 10 comprising the power source unit 111 and the lower case 202 is not removed from the upper case 201, it is determined that the inhalation device 100 has not transitioned to a state in which the power source unit 111 can be removed (step S121: NO).

When the inhalation device 100 has not transitioned to a state in which the power source unit 111 can be removed (step S121: NO loop), the control portion 116 moves to step S124, determines that the power source unit 111 has not been replaced, and ends the determination of whether the power source unit 111 has been replaced in step S100.

If the inhalation device 100 has transitioned to the state in which the power source unit 111 can be removed (step S121: YES), the control unit 116 proceeds to step S122.

After transitioning to the state in which the power source unit 111 can be removed, the user replaces the power source unit 111 by removing the power source unit 111 from the inhalation device 100 and attaching a new power source unit 111 to the inhalation device 100.

Then, when replacement of the power source unit 111 has been completed by attaching the new power source unit 111 to the inhalation device 100, the user transitions the inhalation device 100 to a state in which the power source unit 111 cannot be removed. For example, in "First example of mode of insertion/removal of power source unit" described above, the state in which the power source unit 111 cannot be removed is the state in which the bottom wall portion 21, which can be opened and closed about the hinge portion 21a, is in the closed state and the power source accommodating portion 200 is in the closed state. Also, for example, in "Second example of mode of insertion/removal of power source unit" described previously, the state in which the power source unit 111 cannot be removed is the state in which the panel 30 is attached to the case 20 and the power source accommodating portion 200 is in the closed state. Also, for example, in "Third example of mode of insertion/removal of power source unit" described above, the state in which the power source unit 111 cannot be removed is the state in which the modularized battery pack 10 comprising the power source unit 111 and the lower case 202 is mounted on the upper case 201.

At step S122, the control unit 116 determines whether the inhalation device 100 has transitioned to the state in which the power source unit 111 cannot be removed. If the inhalation device 100 has not transitioned to the state in which the power source unit 111 cannot be removed (loop of step S122: NO), the control unit 116 enters a standby state until the inhalation device 100 transitions to the state in which the power source unit 111 cannot be removed.

If the inhalation device 100 has transitioned to the state in which the power source unit 111 cannot be removed (step S122: YES), the routine proceeds to step S123, and the control unit 116 determines that the power source unit 111 has been replaced (step S100:YES), and ends the determination, at step S100, of whether the power source unit 111 has been replaced.

This makes it possible to determine whether or not the power source unit 111 has been replaced by means of simple control.

### [7. Method for identifying type of power source unit]

Next, first to third examples will be described as examples of the method for identifying the type of power source unit 111 mounted in the power supply unit 110 in the aforementioned step S200. Note that identification of the type of power source unit 111 mounted in the power supply unit 110 may be performed by a method other than the first to third examples. Thus, by enabling the control unit 116 to perform identification processing for identifying the type of power source unit 111 mounted in the power supply unit 110, the type of power source unit 111 mounted on the power supply unit 110 can be identified.

### <7-1. First example of method for identifying type of power source unit mounted in power supply unit>

In the present example, the terminal-to-terminal voltage of the power source unit 111 mounted in the power supply unit 110 and the current flowing between the terminals of the power source unit 111 are measured, and identification of the type of power source unit 111 mounted in the power supply unit 110 is performed on the basis of the measured terminal-to-terminal voltage and current values.

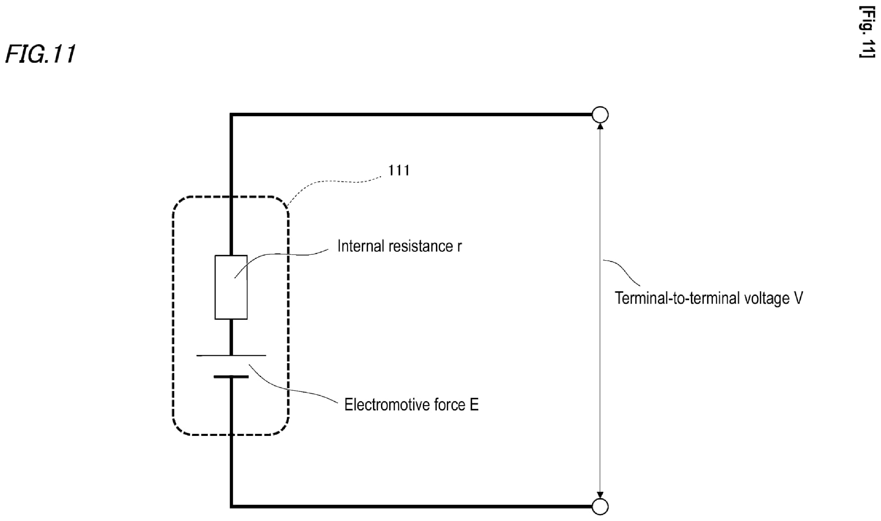

As shown in fig. 11, the power source unit 111 generates an electromotive force E [V] and has an internal resistance r [Ω]. The internal resistance r [Ω] of the power source unit 111 differs depending on the type of power source unit 111. Then, the type of power source unit 111 mounted in the power supply unit 110 is identified by obtaining the value of the internal resistance r [Ω] of the power source unit 111 mounted in the power supply unit 110.

In the present example, the terminal-to-terminal voltage of the power source unit 111 mounted in the power supply unit 110 and the current flowing between the terminals of power source unit 111 are measured. According to the circuit diagram of fig. 11, assuming the terminal-to-terminal voltage of the power source unit 111 is V [V] and the current flowing between the terminals of the power source unit 111 is I [A], the following equation (1) holds: $E \left[V\right] = r \left[Ω\right] ⋅ I \left[A\right] + V \left[V\right]$ (1)

By rearranging equation (1), the following equation (2) is obtained. $V \left[V\right] = E \left[V\right] - r \left[Ω\right] ⋅ I \left[A\right]$ (2)

The electromotive force E [V] of the power source unit 111 can be obtained from the measured value of the terminal-to-terminal voltage V [V] when the value of the current I [A] is zero. That is, the electromotive force E [V] of the power source unit 111 can be acquired by measuring the terminal-to-terminal voltage V [V] in an open circuit. Furthermore, the value of the internal resistance r [Ω] of the power source unit 111 can be acquired by substituting the values of the terminal-to-terminal voltage V [V] and the current I [A] obtained from measurements into equation (2).

The memory unit 114 stores an identification table in which the type of power source unit 111 is associated with the value of the internal resistance r [Ω].

The control unit 116 refers to the identification table stored in the memory unit 114, and identifies the type of power source unit 111 corresponding to the acquired value of the internal resistance r [Ω] as the type of power source unit 111 mounted in the power supply unit 110.

This enables the type of power source unit 111 to be identified simply and at low cost without the need to provide a separate member or the like to identify the type of power source unit 111.

### <7-2. Second example of method for identifying type of power source unit mounted in power supply unit>

In the present example, the power source unit 111 is provided with an identification resistor R2 having a different value for each type of power source unit 111. When the power source unit 111 is supplying power, an identification voltage V2 acts across the identification resistor R2. The power source unit 111 is configured such that the identification voltage V2 is a predetermined voltage for each type of power source unit 111. Then, identification of the type of power source unit 111 mounted in the power supply unit 110 is performed on the basis of the identification voltage V2.

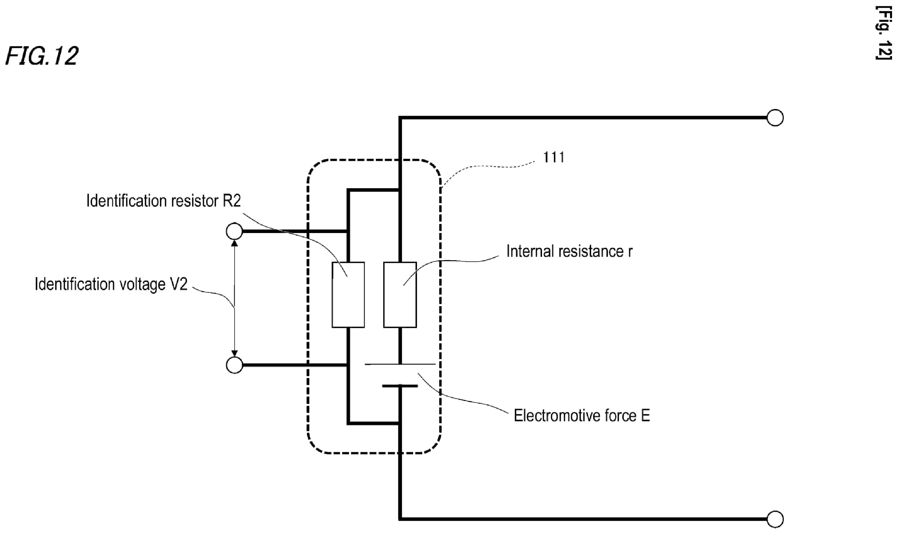

As shown in fig. 12, the power source unit 111 generates an electromotive force E [V] and has an internal resistance r [Ω]. Furthermore, the power source unit 111 is provided with the identification resistor R2, which has a different value for each type of power source unit 111, and when the power source unit 111 is supplying power, the identification voltage V2, which is a predetermined voltage for each type of power source unit 111, acts across the identification resistor R2. The type of power source unit 111 mounted in the power supply unit 110 is then identified by acquiring the value of the identification voltage V2 of the power source unit 111 mounted in the power supply unit 110.

For example, a first type of power source unit 111 is provided with an identification resistance R2 across which the identification voltage V2 of 1 [V] acts, and a second type of power source unit 111 is provided with an identification resistance R2 across which the identification voltage V2 of 2 [V] acts.

This enables more accurate identification of the type of power source unit 111.

### <7-3. Third example of method for identifying type of power source unit mounted in power supply unit>

In the present example, an identification member 111f provided with an identifier capable of identifying the type of power source unit 111 is attached to the power source unit 111. The identification member 111f provided with the identifier may be, for example, a barcode defined for each type of power source unit 111, a two-dimensional code defined for each type of power source unit 111, an integrated circuit (IC) tag to which information relating to the type of power source unit 111 has been written, a radio frequency identification (RFID) tag to which information relating to the type of power source unit 111 has been written, etc.

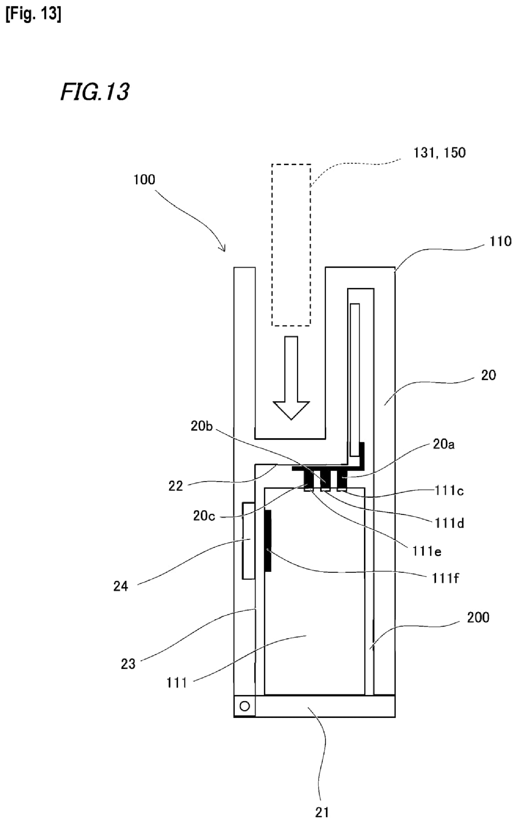

As shown in fig. 13, in the present example, the identification member 111f is attached to the side face of the power source unit 111. Furthermore, a reading sensor 24 is provided at a position facing the identifier of the identification member 111f when the power source unit 111 is correctly mounted in the power supply unit 110. The reading sensor 24 may, for example, be provided on the side wall portion 23 of the power source accommodating portion 200, or may be provided in the upper case 201. The reading sensor 24 reads the identifier of the identification member 111f mounted in the power source unit 111.

Then, identification of the type of power source unit 111 mounted in the power supply unit 110 is performed on the basis of information from the identifier read by the reading sensor 24.

This enables more accurate identification of the type of power source unit 111, as well as enabling more information to be read by the reading sensor 24 from the identifier of the identification member 111f.

In this case, if the identifier provided on the identification member 111f and the reading sensor 24 are not correctly aligned, it may not be possible for the identifier of the identification member 111f mounted on the power source unit 111 to be read by the reading sensor 24.

Therefore, in the power source unit 111, the positive electrode terminal 111c, the negative electrode terminal 111d, and the temperature terminal 111e are preferably provided on the same predetermined surface constituting the outer surface of the power source unit 111. In this case, when the power source unit 111 is mounted in the power supply unit 110, the positive electrode terminal 111c, the negative electrode terminal 111d, and the temperature terminal 111e are electrically connected to the positive terminal connection portion 20a, the negative terminal connection portion 20b, and the temperature terminal connection portion 20c, respectively, by pushing the power source unit 111 in one predetermined direction relative to the case 20. Also, when the power source unit 111 is mounted in the power supply unit 110, the power source unit 111 is aligned by pressing in a predetermined direction relative to the case 20, and it is therefore easier to align the identifier provided on the identification member 111f and the reading sensor 24 correctly.

In this way, by providing the positive electrode terminal 111c, the negative electrode terminal 111d, and the temperature terminal 111e on the same predetermined surface of the power source unit 111 that constitutes the outer surface of the power source unit 111, the positive electrode terminal 111c, the negative electrode terminal 111d, and the temperature terminal 111e can be reliably electrically connected to the positive terminal connection portion 20a, the negative terminal connection portion 20b, and the temperature terminal connection portion 20c, and the identifier provided on the identification member 111f and the reading sensor 24 can be correctly aligned.

In addition, the outer surface of the power source unit 111 may be composed of a plurality of surfaces facing upward, downward, forward, backward, left, and right, and the shape of the power source accommodating portion 200 may be configured to have a surface shape that faces the plurality of surfaces of the power source unit 111.

This prevents the power source unit 111 from shifting position in the power source accommodating portion 200, ensuring that the positive electrode terminal 111c, the negative electrode terminal 111d, and temperature terminal 111e are reliably electrically connected to the positive terminal connection portion 20a, the negative terminal connection portion 20b, and the temperature terminal connection portion 20c, and that the identifier provided on the identification member 111f and the reading sensor 24 are correctly aligned.

### <7-4. Fourth example of method for identifying type of power source unit mounted in power supply unit>

In the present example, the power supply unit 110 of the inhalation device 100 is enabled to communicate with a communication terminal such as a smartphone, a tablet terminal, or a personal computer (PC), and the communication terminal and the power supply unit 110 of the inhalation device 100 are enabled to cooperate via an application installed on the communication terminal.

Then, using the application installed on the communication terminal, the user inputs information about the power source unit 111 attached to the power supply unit 110 of the inhalation device 100, the communication terminal transmits the information about the power source unit 111, input by the user, to the power supply unit 110, and the power supply unit 110 identifies the type of power source unit 111 attached to the power supply unit 110 on the basis of the information about the power source unit 111 received from the communication terminal.

### [8. Configuration example of part relating to charging and discharging of power source unit]

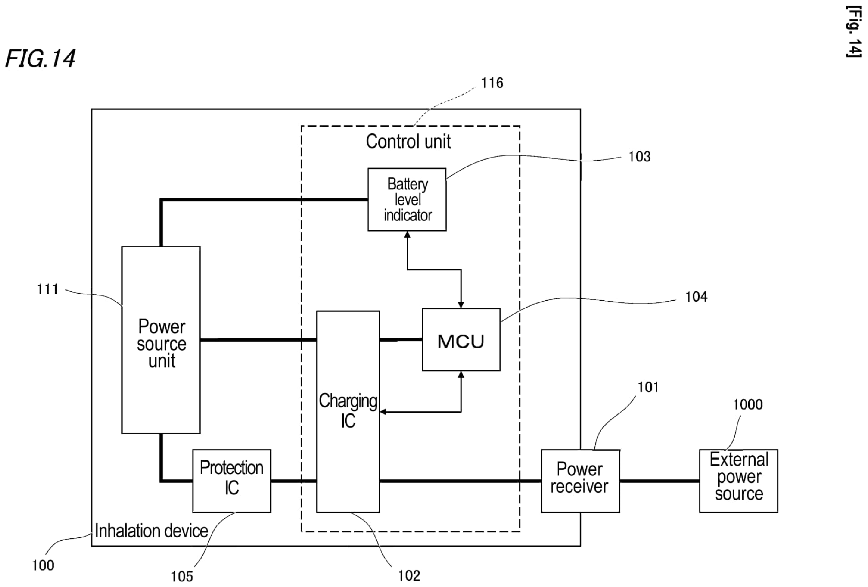

Fig. 14 is a schematic diagram schematically showing one configuration example of the part of the inhalation device 100 that relates to charging and discharging of the power source unit 111. In fig. 14, the thick solid lines denote electrical wiring, and the solid line arrows denote control signals or detection signals.

As shown in fig. 14, in addition to the power source unit 111, the inhalation device 100 further comprises: a power receiver 101, a charging IC 102, a battery level indicator 103, an MCU 104, and a protection IC 105, for example. The control unit 116 discussed hereinabove includes, for example, the charging IC 102, the battery level indicator 103, and the MCU 104, etc., shown in fig. 14.

The power source unit 111 is configured to be capable of being charged by means of power received from the external power source 1000. Here, the external power source 1000 is a device configured to be capable of outputting predetermined power. Furthermore, the predetermined power is power that the inhalation device 100 is capable of receiving in terms of hardware, and may be, for example, DC power having a predetermined voltage (for example, 5 to 20 [V]). The external power source 1000 may be an alternating current (AC) adapter configured to be capable of outputting the specific power, for example. Furthermore, the external power source 1000 is not limited to an AC adapter, and may be, for example, a portable charger (also referred to as a mobile battery), a PC (personal computer), a smartphone, or a tablet terminal, for example.

The power source unit 111 is configured to be capable of supplying stored power to each component of the inhalation device 100, such as the charging IC 102, the battery level indicator 103, the MCU 104, and the heating unit 121 (not shown in fig. 14). It should be noted that fig. 14 shows an example in which power is supplied directly from the power source unit 111 to the MCU 104, but this is not limiting. For example, power may also be supplied from the power source unit 111 to the MCU 104 via the charging IC 102.

The power receiver 101 is configured to be capable of receiving power output from the external power source 1000. As an example, the power receiver 101 may be an external connection terminal provided in the case 20 that can be electrically connected to the external power source 1000. The external connection terminal is, for example, a receptacle to which a connector such as Universal Serial Bus (USB) or the like can be connected. Furthermore, the power receiver 101 may be a power-receiving coil, or similar, which is configured to be capable of contactlessly receiving power delivered from the external power source 1000. In this case, the method of contactless power transfer (WPT: wireless power transfer) may employ electromagnetic induction, magnetic resonance, or a combination of electromagnetic induction and magnetic resonance.

The charging IC 102 is an integrated circuit (IC) which is electrically provided between the power receiver 101 and the power source unit 111, and is configured to be capable of controlling charging of the power source unit 111 with the power received from the external power source 1000 via the power receiver 101.

As an example, when there is a request to start charging from the user, the charging IC 102 starts charging of the power source unit 111 with the power received from the external power source 1000. Here, the request to start charging may be the establishment of an electrical connection between the inhalation device 100 and the external power source 1000, for example. Furthermore, the request to start charging may further comprise the performance of a predetermined operation once the electrical connection between the inhalation device 100 and the external power source 1000 has been established. Pressing a predetermined operation button provided on the inhalation device 100 is a possible example of this operation. Furthermore, this operation is not limited to a direct operation on the inhalation device 100, and it may equally be an operation on another device such as a smartphone which is capable of communicating with the inhalation device 100, for example.

The charging IC 102 controls the power for charging the power source unit 111 when charging the power source unit 111. A constant current charging current value Icc [A], a constant voltage charging voltage value Vcv [V], a charging switching voltage Vc [V], and an end-of-charging voltage Ve [V] are set in the charging IC 102 and stored in memory. The charging IC 102 controls the power used to charge the power source unit 111, on the basis of the constant current charging current value Icc [A], the constant voltage charging voltage value Vcv [V], the charging switching voltage Vc [V], and the end-of-charging voltage Ve [V] stored in memory. Details of the charging control of the power source unit 111 by the charging IC 102 are described later.

The battery level indicator 103 is an integrated circuit (IC) that measures the state of charge (SOC) of the power source unit 111. The battery level indicator 103 periodically measures the open circuit voltage between the terminals of the power source unit 111 and calculates the remaining charge of the power source unit 111 on the basis of the measured open circuit voltage of the power source unit 111.

The battery level indicator 103 uses a current sensing resistor to accumulate the amount of current that flows into the power source unit 111 during charging, and measures the amount of current that flows out of the power source unit 111 during discharge, and, on the basis of the amount of current that flows into the power source unit 111 during charging and the amount of current that flows out of the power source unit 111 during discharge, periodically calculates the remaining charge of the power source unit 111 and stores the same in the memory of the battery level indicator 103. Note that the battery level indicator 103 may also store measurement data such as the discharge properties (under no load) and temperature properties of the power source unit 111 in memory, and periodically measure the voltage, current, and temperature of the power source unit 111 while it is operating to calculate the impedance of the power source unit 111, and may periodically calculate the remaining charge of the power source unit 111 on the basis of the calculated impedance of the power source unit 111.

Here, a discrepancy may occur between the remaining charge of the power source unit 111 calculated on the basis of the open circuit voltage of the power source unit 111 and the actual remaining charge of the power source unit 111 due to degradation over time, etc., of the power source unit 111.

Accordingly, when the operating mode of the inhalation device 100 is the sleep mode, the battery level indicator 103 measures the open circuit voltage of the power source unit 111 and calculates the remaining charge of the power source unit 111 on the basis of the open circuit voltage. The battery level indicator 103 then calculates a correction value from the difference between the remaining charge of the power source unit 111 calculated on the basis of the open circuit voltage and the remaining charge of the power source unit 111 previously stored in the memory of the battery level indicator 103. Calculation of the correction value is performed periodically, and the correction value is over-written and stored in the memory of the battery level indicator 103.

The battery level indicator 103 then calculates a corrected remaining charge of the power source unit 111, which is corrected to be a more accurate remaining charge, on the basis of the remaining charge of the power source unit 111 calculated on the basis of the amount of current that flowed into the power source unit 111 during charging and the amount of current that flowed out of the power source unit 111 during discharge, and the correction value stored in the memory of the battery level indicator 103. The notification unit 113 may be notified of the calculated corrected remaining charge of the power source unit 111.

Also, when a new power source unit 111 is mounted in the power supply unit 110, and a predetermined operation is performed, such as the user operating the operation portion 15 or connecting an external power source 1000 to the power receiver 101, and the operating mode of the inhalation device 100 switches from shipping mode to standby mode or sleep mode, the battery level meter 103 measures, by means of a command from the MCU 104, the open-circuit voltage of the power source unit 111 and calculates the remaining charge of the power source unit 111 on the basis of the open-circuit voltage. Then, starting from the remaining charge in the power source unit 111 calculated on the basis of the open circuit voltage, the battery level indicator 103 calculates the remaining charge in the power source unit 111 on the basis of the amount of current that has flowed into the power source unit 111 during charging and the amount of current that has flowed out of the power source unit 111 during discharging.

At this time, if the battery level meter 103 uses the correction value that was stored in memory when the power source unit 111 prior to replacement was installed to correct the remaining charge of the power source unit 111 calculated on the basis of the amount of current that has flowed into the power source unit 111 during charging and the amount of current that has flowed out of the power source unit 111 during discharging, the corrected remaining charge of the power source unit 111 installed in the power supply unit 110 after replacement will be a value that deviates from the actual remaining charge of the power source unit 111.

Accordingly, when the MCU 104 determines that the power source unit 111 installed in the power supply unit 110 has been replaced, the battery level indicator 103, in accordance with an instruction from the MCU 104, erases the remaining charge of the power source unit 111 stored in memory, calculated on the basis of the amount of current that has flowed into the power source unit 111 during charging and the amount of current that has flowed out of the power source unit 111 during discharging, and the correction value stored in memory. Then, after it has been determined that the power source unit 111 mounted in the power supply unit 110 has been replaced, the remaining charge of the power source unit 111 calculated on the basis of the amount of current that has flowed into the power source unit 111 during charging and the amount of current that has flowed out of the power source unit 111 during discharging, and the correction value calculated after it has been determined that the power source unit 111 mounted in the power supply unit 110 has been replaced, are newly stored in memory.

An upper limit current Imax [A] for determining whether the power discharged from the power source unit 111 is an overcurrent and an upper limit voltage Vmax [V] for determining whether the power discharged from the power source unit 111 is an overvoltage are set in the battery level indicator 103 and are stored in memory. The battery level indicator 103 interrupts discharging from the power source unit 111 when the power discharged from the power source unit 111 exceeds the upper limit current Imax [A] and when the power discharged from the power source unit 111 exceeds the upper limit voltage Vmax [V].

Furthermore, a nominal voltage Vn [V] of the power source unit 111 and a charge capacity CC [Ah] are set in the battery level indicator 103 and are stored in memory. The nominal voltage Vn [V] is a voltage value defined as an indication of the terminal-to-terminal voltage obtained when the power source unit 111 is used under normal conditions. The charge capacity CC [Ah] is the maximum amount of electrical charge released by the power source unit 111 from a fully charged state.

The MCU 104 is a computer that is mainly configured by a processor for implementing various types of arithmetic processing, and performs integrated control of the inhalation device 100 as a whole in accordance with a pre-prepared program. Components controlled by the MCU 104 include the charging IC 102 and the battery level indicator 103, etc.

A threshold voltage Vth [V] is set in the MCU 104 and is stored in memory. The threshold voltage Vth [V] is a voltage value for determining whether the amount of power required to complete heating of one flavor source 131 or stick-type substrate 150 is left as the remaining charge of the power source unit 111. The threshold voltage Vth [V] is used in the flow for determining whether heating control of the inhalation device 100 is possible, as will be described later.

The protection IC 105 is an integrated circuit (IC) that protects the power source unit 111 from overcharging, over-discharging, overvoltage, overcurrent, short circuits, etc. The protection IC 105 operates independently of the control unit 116.

A forced stop current Ifs [A] and a forced stop voltage Vfs [V] are set in the protection IC 105 and are stored in memory. The forced stop current Ifs [A] is set to a value greater than the upper limit current Imax [A] set in the battery level indicator 103. The protection IC 105 forces discharging from the power source unit 111 to stop when the current of the power discharged from the power source unit 111 is greater than or equal to the forced stop current Ifs [A]. The forced stop voltage Vfs [V] is set to a value greater than the upper limit voltage Vmax [V] set in the battery level indicator 103. The protection IC 105 forces discharge from the power source unit 111 to stop when the voltage of the power discharged from the power source unit 111 is greater than or equal to the forced stop voltage Vfs [V].

In this way, the power source unit 111 is doubly protected from overcurrent and overvoltage by the battery level indicator 103 and the protection IC 105. Under normal conditions, the power discharged from the power source unit 111 is controlled by the battery level indicator 103 to be less than or equal to the upper limit current Imax [A] and less than or equal to the upper limit voltage Vmax [V]. Furthermore, even in the event that a fault occurs in the battery level indicator 103, the power discharged from the power source unit 111 is controlled by the protection IC 105 to be less than or equal to the forced stop current Ifs [A] and less than or equal to the forced stop voltage Vfs [V].

### [9. Processing for modifying various control values used to control power source unit]

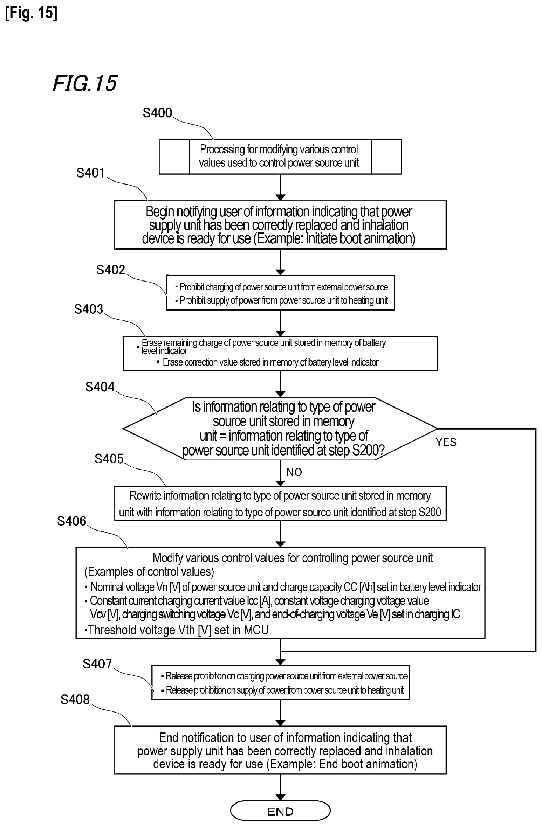

Next, the processing for modifying various control values used to control the power source unit 111, carried out at step S400, will be described with reference to fig. 15.

Triggered by the fact that, in step S200, the control unit 116 was able to identify the type of power source unit 111 mounted in the power supply unit 110 (step S300: YES), in step S400 the control unit 116 performs processing for modifying various control values for controlling the power supply unit 111.

The control unit 116 first proceeds to step S401, where it controls the notification unit 113 to begin notifying the user of information indicating that the power supply unit 111 has been correctly replaced and the inhalation device 100 is ready for use. If the notification unit 113 is a display device that displays an image, a boot animation is initiated, for example.

The control unit 116 then proceeds to step S402 where it controls the charging IC 102 to prevent charging of the power source unit 111 from the external power source 1000, and controls the MCU 104 to prevent the supply of power from the power source unit 111 to the heating unit 121. The routine then moves to step S403.

At step S403, the control unit 116 erases the remaining charge of the power source unit 111 stored in the memory of the battery level indicator 103, calculated on the basis of the amount of current that has flowed into the power source unit 111 during charging and the amount of current that has flowed out of the power source unit 111 during discharging, and the correction value stored in the memory of the battery level indicator 103.

This can prevent the power source unit 111 mounted in the power supply unit 110 after replacement from being controlled using a correction value corresponding to the power source unit 111 mounted on the power supply unit 110 prior to replacement, and thus the power source unit 111 mounted in the power supply unit 110 after replacement can be more appropriately controlled.

The control unit 116 then proceeds to step S404, where it compares the information relating to the type of power source unit 111, stored in the memory unit 114 as the type of power source unit 111 installed in the power supply unit 110, with the information relating to the type of power source unit 111 identified in step S200, and determines whether or not they are the same.

If, at step S404, the information relating to the type of power source unit 111 stored in the memory unit 114 as the type of power source unit 111 mounted in the power supply unit 110 and the information relating to the type of power source unit 111 identified in step S200 are the same (step S404: YES), the control unit 116 does not modify the various control values for controlling the power source unit 111, and proceeds to step S407.

If, at step S404, the information relating to the type of power source unit 111 stored in the memory unit 114 as the type of power source unit 111 mounted in the power supply unit 110 and the information relating to the type of power source unit 111 identified in step S200 are different (step S404: NO), the control unit 116 proceeds to step S405.

At step S405, the control unit 116 rewrites the information relating to the type of power source unit 111 stored in the memory unit 114 as the type of power source unit 111 mounted in the power supply unit 110 to the information relating to the type of power source unit 111 as identified at step S200. The routine then moves to step S406.

At step S406, the control unit 116 modifies various control values for controlling the power source unit 111 on the basis of the information relating to the power source unit 111, stored in the memory unit 114.

Specifically, the control unit 116 modifies the nominal voltage Vn [V] and the charge capacity CC [Ah] of the power source unit 111, set in the battery level indicator 103, the constant current charging current value Icc [A], the constant voltage charging voltage value Vcv [V], the charging switching voltage Vc [V] and the charging stop voltage Ve [V], set in the charging IC 102, and the threshold voltage Vth [V] set in the MCU 104.

The memory unit 114 stores a control value table that associates a plurality of types of power source unit 111 with the nominal voltage Vn [V], the charge capacity CC [Ah], the constant current charging current value Icc [A], the constant voltage charging voltage value Vcv [V], the charging switching voltage Vc [V], the end-of-charging voltage Ve [V], and the threshold voltage Vth [V] for the corresponding type of power source unit 111.

In step S406, the control unit 116 refers to the information relating to the type of power source unit 111 stored in the memory unit 114 and the control value table, and retrieves the nominal voltage Vn [V], the charge capacity CC [Ah], the constant current charging current value Icc [A], the constant voltage charging voltage value Vcv [V], the charging switching voltage Vc [V], the end-of-charging voltage Ve [V], and the threshold voltage Vth [V] corresponding to the type of power source unit 111 stored in the memory unit 114. Then, the control unit 116 modifies the nominal voltage Vn [V] and charge capacity CC [Ah] of the power source unit 111 set in the battery level indicator 103, the constant current charging current value Icc [A], the constant voltage charging voltage value Vcv [V], the charging switching voltage Vc [V], and the end-of-charging voltage Ve [V] set in the charging IC 102, and the threshold voltage Vth [V] set in the MCU 104 to the retrieved nominal voltage Vn [V], charge capacity CC [Ah], constant current charging current value Icc [A], constant voltage charging voltage value Vcv [V], charging switching voltage Vc [V], charging termination voltage Ve [V], and threshold voltage Vth [V].

This enables the appropriate nominal voltage Vn [V], charge capacity CC [Ah], constant current charging current value Icc [A], constant voltage charging voltage value Vcv [V], charging switching voltage Vc [V], end-of-charging voltage Ve [V], and threshold voltage Vth [V to be set in the battery level indicator 103, in accordance with the type of power source unit 111.

However, the upper limit current Imax [A] and the upper limit voltage Vmax [V] set in the battery level indicator 103 are not modified. Note that the protection IC 105 operates independently of the control unit 116, and the forced stop current Ifs [A] and forced stop voltage Vfs [V] set in the protection IC 105 are not modified by the control unit 116.

Even though the upper limit current Imax [A] and upper limit voltage Vmax [V] set in the battery level indicator 103 are not modified, the power discharged from the power supply unit 111 is controlled to be less than or equal to the forced stop current Ifs [A] and less than or equal to the forced stop voltage Vfs [V] by the protection IC 105, which operates independently of the control unit 116. Therefore, the power discharged from the power source unit 111 can be safely controlled even if the upper limit current Imax [A] and upper limit voltage Vmax [V] set in the battery level indicator 103 are not modified. As a result, by not changing the upper limit current Imax [A] or upper limit voltage Vmax [V] set in the battery level indicator 103, the number of times the upper limit current Imax [A] and upper limit voltage Vmax [V] are written to the memory of the battery level indicator 103 can be reduced, thereby extending the service life of the battery level indicator 103.

When modification of the various control values for controlling the power source unit 111, at step S406, is complete, the control unit 116 proceeds to step S407.

In step S407, the control unit 116 controls the charging IC 102 to release the prohibition on charging the power source unit 111 from the external power supply 1000 that was imposed in step S402, and also controls the MCU 104 to release the prohibition on supplying power from the power source unit 111 to the heating unit 121 that was imposed in step S402. The routine then moves to step S408.

At step S408, the control unit 116 controls the notification unit 113 to end the notification to the user that the power source unit 111 has been correctly replaced and that the inhalation device 100 is ready for use. If the notification unit 113 is a display device that displays an image, the boot animation is terminated, for example. The processing for modifying various control values for controlling the power source unit 111 is then ended.

In this way, at least one of a plurality of control values used to control the power source unit 111 is modified on the basis of the type of power source unit 111, and at least one of the plurality of control values used to control the power source unit 111 is not modified on the basis of the type of power source unit 111.

This enables the power source unit 111 to be controlled appropriately in accordance with the type of power source unit 111, and since the rewriting of the control values can be reduced to the minimum necessary, the load on the control unit 116 can be reduced and the service life of the control unit 116 can be extended.

Also, the time during which the inhalation device 100 is not available for use due to the replacement of the power source unit 111 can be reduced because the modifications to the various control values used to control the power source unit 111 are carried out between the start of the notification to the user that the power source unit 111 has been correctly replaced and that the inhalation device 100 is ready for use and the end of the notification.

Also, the safety of the inhalation device 100 is improved because charging and discharging of the power source unit 111 are prevented while the various control values used for controlling the power source unit 111 are being modified.

While steps S401 to S408 are being performed, the control unit 116 may monitor whether the inhalation device 100 has transitioned to a state in which the power supply unit 111 can be removed, and if the inhalation device 100 has transitioned to a state in which the power supply unit 111 can be removed, the control unit 116 may temporarily stop implementation of steps S401 to S408. If it is subsequently detected that the inhalation device 100 has transitioned to a state in which the power source unit 111 cannot be removed, implementation of step S401 to step S408 may be resumed. If the inhalation device 100 transitions to the state in which the power source unit 111 can be removed while step S406 is being performed, in other words, while various control values for controlling the power source unit 111 are being modified, the control unit 116 may store the control values that have been modified and the control values that have not been modified, and when it is detected that the inhalation device 100 has transitioned to a state in which the power source unit 111 cannot be removed and the implementation of steps S401 to S408 is resumed, the control unit 116 may modify only the control values for which the modification has not been completed. Also, if the inhalation device 100 transitions to the state in which the power source unit 111 can be removed while step S406 is being performed, in other words, while various control values for controlling the power supply unit 111 are being modified, the control unit 116 may once again change all the control values that were to be changed upon detecting that the inhalation device 100 has transitioned to the state in which the power source unit 111 cannot be removed and the implementation of steps S401 to S408 has resumed.

This prevents the power source unit 111 from being removed while the various control values used to control the power source unit 111 are being modified, thereby making it possible to prevent failure of the inhalation device 100.

Note that in this embodiment, the processing for modifying various control values for control the power supply unit 111 at step S400 is triggered by the fact that it has been possible to identify the type of power source unit 111 mounted in the power supply unit 110 in step S200 (step S300: YES), but the processing for changing the various control values for controlling the power source unit 111 may equally be triggered by the user performing a heating start operation or by the user requesting the start of charging.

### [10. Flow for determining whether heating can be controlled in inhalation device]

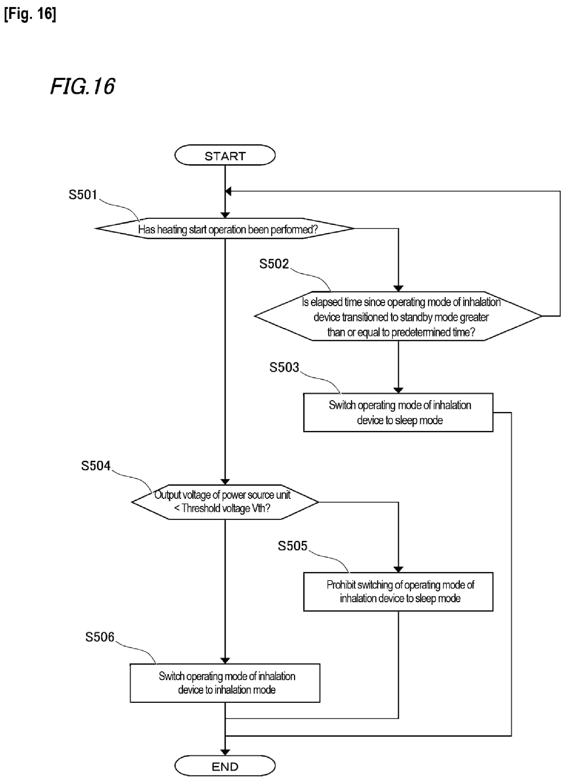

Next, a flow for determining whether heating can be controlled in the inhalation device 100 will be described with reference to fig. 16.

The control unit 116 determines whether a heating start operation has been performed on the inhalation device 100 by the user when the operating mode of the inhalation device 100 is the standby mode (step S501). If no heating start operation has been performed by the user (step S501: NO), the routine proceeds to step S502 to determine whether the elapsed time since the operating mode of the inhalation device 100 transitioned to the standby mode is greater than or equal to a predetermined time. If the elapsed time since the operating mode of the inhalation device 100 transitioned to the standby mode is not more than the predetermined time (step S502: NO), the routine returns to step S501 and waits for a heating start operation to be performed by the user. If the elapsed time since the operating mode of the inhalation device 100 transitioned to the standby mode is greater than or equal to the predetermined time (step S502: YES), the routine proceeds to step S503 to switch the operating mode of the inhalation device 100 to the sleep mode and ends the series of controls.

The control unit 116 proceeds to step S504 if a heating start operation is performed by the user (step S501: YES) when the operating mode of the inhalation device 100 is the standby mode.

At step S504, the control unit 116 determines whether the amount of power required to complete heating of one flavor source 131 or stick-type substrate 150 is left as the remaining charge of the power source unit 111.

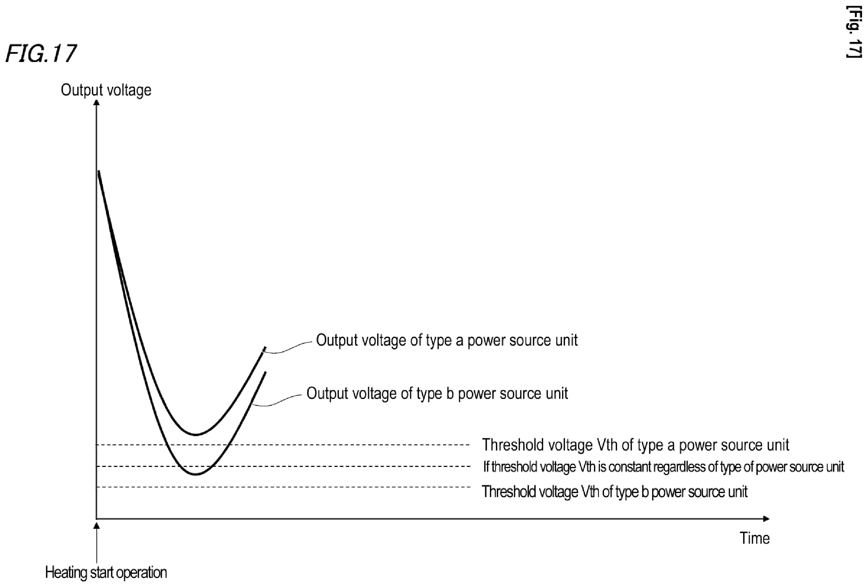

In particular, referring also to fig. 17, the control unit 116 supplies power to the heating unit 121 for a short period of time at step S504, and determines whether the output voltage of the power source unit 111 has fallen below the threshold voltage Vth [V] stored in the memory. At step S504, if the output voltage of the power source unit 111 has fallen below the threshold voltage Vth [V] (step S504: YES), the control unit 116 determines that the amount of power required to complete heating of one flavor source 131 or stick-type substrate 150 is not left as the remaining charge of the power source unit 111 and that heating control cannot be performed, prohibits switching of the operating mode to the inhalation mode (step S505), and ends the series of controls. As a result, the control unit 116 cannot perform heating control of the heating unit 121.

At step S504, if the output voltage of the power source unit 111 has not fallen below the threshold voltage Vth [V] (step S504: NO), the control unit 116 determines that the amount of power required to complete heating of one flavor source 131 or stick-type substrate 150 is left as the remaining charge of the power source unit 111 and that heating control can be performed, switches the operating mode to the inhalation mode (step S506), and ends the series of controls. The control unit 116 then carries out heating control of the heating unit 121 when the operating mode is switched to the inhalation mode.

Here, for example, assume that there are a type a power source unit 111 and a type b power source unit 111, and that the value of the internal resistance is greater for the type b power source unit 111 than for the type a power source unit 111. In this case, if the remaining charge of each is the same, the voltage drop that occurs when the heating unit 121 is powered for a short period of time will be greater for the type b power source unit 111 than for the type a power source unit 111.

Therefore, if the threshold voltage Vth [V] is set to a constant value regardless of the type of power source unit 111, it may be determined that heating control cannot be performed for the type b power source unit 111, even though the amount of power required to complete heating of one flavor source 131 or stick-type substrate 150 is left as the remaining charge.

The threshold voltage Vth [V] is set to a lower value for types of power source units 111 having a higher internal resistance and to a higher value for types of power source units 111 having a lower internal resistance.

Thus, an appropriate threshold voltage Vth [V] is set in accordance with the type of power source unit 111, enabling proper determination of whether heating control can be performed in the inhalation device 100.

Furthermore, secondary batteries such as lithium-ion batteries generally degrade with repeated charging and discharging, and the actual charge capacity decreases. In light of this, the control unit 116, for example the MCU 104, may count and store in its memory the number of times the heating control has been performed since it was determined that the power source unit 111 mounted in the power supply unit 110 was replaced, and the battery level indicator 103 may be controlled to decrease the charge capacity CC [Ah] by a predetermined value (for example, 50 [mAh]) each time heating control is performed a predetermined number of times (for example, 100 times). This control may, for example, be carried out each time immediately after the number of times of heating control being performed, since the power source unit 111 mounted in the power supply unit 110 is determined to have been replaced, reaches the predetermined number of times (for example, 100 times).

As a result, a value closer to the actual value can be set as the charge capacity CC [Ah] of the power source unit 111 in the battery level indicator 103.

### [11. Charging control of power source unit]

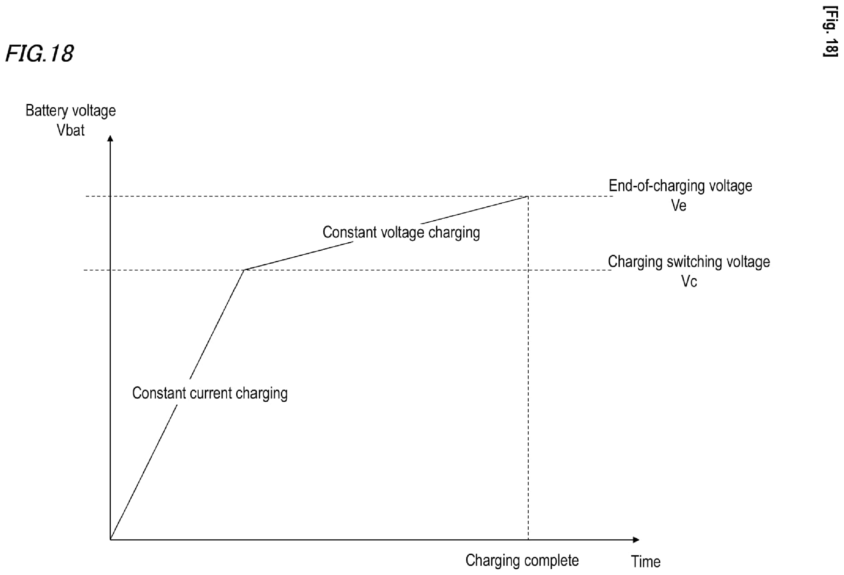

Next, charging control of the power source unit 111 in the inhalation device 100 will be described with reference to fig. 18.

In the inhalation device 100, when the charging IC 102 receives an instruction to start charging from the MCU 104, charging control of the power source unit 111 is performed on the basis of control values set in the charging IC 102.

Four charging of the power source unit 111, the charging IC 102 performs constant current charging when the battery voltage Vbat [V] is less than the charging switching voltage Vc [V], switches to constant voltage charging when the battery voltage Vbat [V] is greater than or equal to the charging switching voltage Vc [V], and finishes charging the power source unit 111 when the end-of-charging voltage Ve [V] is reached.

When the charging IC 102 performs constant current charging, it charges the power source unit 111 using the constant current charging current value Icc [A] stored in the memory. When the charging IC 102 performs constant voltage charging, it charges the power source unit 111 using the constant voltage charging voltage value Vcv [V] stored in the memory.

The magnitude of the current that can flow and the battery voltage Vbat at full charge differ depending on the type of power source unit 111.

Therefore, if, for sake of argument, the constant current charging current value Icc [A] and the constant voltage charging voltage value Vcv [V] are fixed values regardless of the type of power source unit 111, the inconvenience of a longer charging time may arise depending on the type of power source unit 111.

In the present disclosure, an appropriate constant current charging current value Icc [A] and constant current charging voltage value Vcv [V] are set in accordance with the type of power source unit 111, enabling efficient charging of the power source unit 111 in a short time.

Also, if, for sake of argument, the end-of-charging voltage Ve [V] is a fixed value regardless of the type of power source unit 111, the inconvenience of charging of the power source unit 111 ending before the power source unit 111 has reached a fully charged state may arise depending on the type of power source unit 111.

In the present disclosure, an appropriate end-of-charging voltage Ve [V] is set in accordance with the type of power source unit 111, and thus the power source unit 111 can be reliably charged to a fully charged state.

Embodiments of the present invention have been described hereinabove, but the present invention is not limited to the above embodiments, and modifications and improvements may be made, as appropriate.

For example, in this embodiment, the power source unit 111 is replaced after the operating mode of the inhalation device 100 has transitioned to the shipping mode, but the operating mode for replacing the power source unit 111 is not limited to the shipping mode, and may also be the standby mode or any operating mode in which the power consumption of the inhalation device 100 is lower than that of the standby mode, and, for example, there may be a dedicated operating mode for replacing the power source unit 111, and the power source unit 111 may be replaced after the operating mode of the inhalation device 100 has been switched to the dedicated operating mode for replacing the power source unit 111.

The present specification sets forth at least the following features. Corresponding components, and so on, in the embodiments described above are shown by way of example in parentheses, but there is no limitation to such components.

(1) A power supply unit (power supply unit 110 for an aerosol-generating device) that generates an aerosol by heating an aerosol source, the power supply unit comprising: a power source unit (power source unit), and
   a control unit (control unit 116) configured to control at least one of charging and discharging of the power source unit,
   wherein
   the power source unit is replaceably and removably mounted in the power supply unit, and the control unit can perform:
      identification processing for identifying the type of power source unit mounted in the power supply unit, and
      control value modification processing for modifying, on the basis of the type of power source unit identified in the identification processing, at least one control value used to control the power source unit,
         and
      at least one of the control values used for controlling the power source unit is not modified by the control value modification processing.

According to (1), the power source unit can be controlled appropriately in accordance with the type of power source unit, and since rewriting of the control values can be reduced to the minimum necessary, the load on the control unit can be reduced and the service life of the control unit can be extended.

(2) The power supply unit for an aerosol-generating device according to (1), wherein
   the control unit has a battery level indicator (battery level indicator 103) that measures the remaining charge of the power source unit;
   the nominal voltage (nominal voltage Vn) of the power source unit mounted in the power supply unit is set in the battery level indicator, and
   the control value modified in the control value modification processing includes the nominal voltage.

According to (2), an appropriate nominal voltage can be set in the battery level indicator according to the type of power source unit mounted in the power supply unit.

(3) The power supply unit for an aerosol-generating device according to (1), wherein
the control unit has a battery level indicator (battery level indicator 103) that measures the remaining charge of the power source unit;
the charge capacity (charge capacity CC) of the power source unit mounted in the power supply unit is set in the battery level indicator, and
the control value modified in the control value modification processing includes the charge capacity.

According to (3), an appropriate charge capacity can be set in the battery level indicator according to the type of power source unit mounted in the power supply unit.

(4) The power supply unit for an aerosol-generating device according to (3), wherein the control unit
can perform heating control for heating the aerosol source to generate an aerosol,
counts and stores the number of times the heating control has been performed since the power source unit mounted in the power supply unit was replaced, and
modifies the charge capacity set in the battery level indicator each time the number of implementations of the heating control reaches a predetermined number.

According to (4), a value closer to the actual value can be set as the charge capacity of the power source unit in the battery level indicator.

(5) The power supply unit for an aerosol-generating device according to (1), wherein the control unit
has a controller (MCU 104) capable of performing processing for determining whether heating control is possible, for determining, on the basis of whether the output voltage of the power source unit has fallen below a threshold voltage (threshold voltage Vth), whether heating control for heating the aerosol source to generate an aerosol is possible;
the threshold voltage is set in the controller; and
the control value modified in the control value modification processing includes the threshold voltage.

According to (5), an appropriate threshold voltage is set according to the type of power source unit mounted in the power supply unit, enabling proper determination of whether heating control can be performed in the inhalation device.

(6) The power supply unit for an aerosol-generating device according to (1), wherein
the control unit has a charging IC (charging IC 102) configured to be capable of controlling charging of the power source unit by means of power received from an external power source (external power source 1000);
an end-of-charging voltage (end-of-charging voltage Ve), which is a voltage value for ending charging of the power source unit, is set in the charging IC, and
the control value modified in the control value modification processing includes the end-of-charging voltage.

According to (6), an appropriate end-of-charging voltage is set according to the type of power source unit mounted in the power supply unit, enabling reliable charging of the power source unit to a full charge state.

(7) The power supply unit for an aerosol-generating device according to (1), wherein
the power supply unit has a protection IC (protection IC 105) that protects the power source unit from overcharge, overdischarge, overvoltage, overcurrent, and short circuit,
the control unit has a battery level indicator (battery level indicator 103) that measures the remaining charge of the power source unit;
in the battery level indicator, there are set:
   an upper limit current (upper limit current Imax) for determining whether power discharged from the power source unit is overcurrent; and
   an upper limit voltage (upper limit voltage Vmax) for determining whether power discharged from the power source unit is overvoltage,
   and
a forced stop current (forced stop current Ifs) and a forced stop voltage (forced stop voltage Vfs) are set in the protection IC,
the protection IC stops discharge from the power source unit when power discharged from the power source unit reaches or exceeds the forced stop current or the forced stop voltage,
the forced stop current is a value larger than the upper limit current,
the forced stop voltage is a value larger than the upper limit voltage, and
the control values not modified by the control value modification processing include at least one of the upper limit current and the upper limit voltage.

According to (7), even if the upper limit current and upper limit voltage set in the battery level indicator are not modified, power discharged from the power source unit is controlled by the protection IC so as to be at or below the forced stop current and at or below the forced stop voltage. As a result, power discharged from the power source unit can be safely controlled, and by not modifying at least one of the upper limit current and upper limit voltage, the number of times of writing the upper limit current and upper limit voltage to the battery level indicator can be reduced, thereby make it possible to extend the service life of the battery level indicator.

(8) The power supply unit for an aerosol-generating device according to any of (1) to (7), wherein
the control unit
notifies a user that the power source unit has been correctly replaced and that the aerosol-generating device has become usable when the power source unit is correctly replaced and the aerosol-generating device becomes usable, and
modification of the control values used for controlling the power source unit is performed between the start and end of the notification.

According to (8), since modification of the control values used for controlling the power source unit is performed between the start and end of notification to the user that the power source unit has been correctly replaced and that the aerosol-generating device has become usable, the time for which the aerosol-generating device cannot be used due to replacement of the power source unit can be shortened.

(9) The power supply unit for an aerosol-generating device according to any one of (1) to (7), wherein
the control unit
prohibits charging and discharging of the power source unit during modification of the control values used for controlling the power source unit.

According to (9), since charging and discharging of the power source unit are prohibited during modification of the control values used for controlling the power source unit, safety of the aerosol-generating device is improved.

(10) The power supply unit for an aerosol-generating device according to any one of (1) to (7), wherein
the control unit temporarily stops implementation of the control value modification processing when the aerosol-generating device transitions to a state in which the power source unit can be removed while the control value modification processing is being implemented.

According to (10), since removal of the power source unit from the power supply unit during modification of the control values used for controlling the power source unit is prevented, occurrence of failure in the aerosol-generating device can be inhibited.

### REFERENCE SIGNS LIST

100 Inhalation device (aerosol-generating device)
103 Battery level indicator
110 Power supply unit
116 Control unit
1000 External power source
102 Charging IC
105 Protection IC
104 MCU (controller)
CC Charge capacity
Ifs Forced stop current
Imax Upper limit current
Ve End-of-charging voltage
Vfs Forced stop voltage
Vmax Upper limit voltage
Vn Nominal voltage
Vth Threshold voltage

## Claims

1. A power supply unit for an aerosol-generating device that generates an aerosol by heating an aerosol source, the power supply unit comprising: a power source unit, and
a control unit configured to control at least one of charging and discharging of the power source unit,
wherein
the power source unit is replaceably and removably mounted in the power supply unit, and
the control unit can perform:
identification processing for identifying the type of power source unit mounted in the power supply unit, and
control value modification processing for modifying, on the basis of the type of power source unit identified in the identification processing, at least one control value used to control the power source unit,
and
at least one of the control values used for controlling the power source unit is not modified by the control value modification processing.

2. The power supply unit for an aerosol-generating device as claimed in claim 1, wherein
the control unit has a battery level indicator that measures the remaining charge of the power source unit;
the nominal voltage of the power source unit mounted in the power supply unit is set in the battery level indicator, and
the control value modified in the control value modification processing includes the nominal voltage.

3. The power supply unit for an aerosol-generating device as claimed in claim 1, wherein
the control unit has a battery level indicator that measures the remaining charge of the power source unit;
the charge capacity of the power source unit mounted in the power supply unit is set in the battery level indicator, and
the control value modified in the control value modification processing includes the charge capacity.

4. The power supply unit for an aerosol-generating device as claimed in claim 3, wherein
the control unit
can perform heating control for heating the aerosol source to generate an aerosol,
counts and stores the number of times the heating control has been performed since the power source unit mounted in the power supply unit was replaced, and
modifies the charge capacity set in the battery level indicator each time the number of implementations of the heating control reaches a predetermined number.

5. The power supply unit for an aerosol-generating device as claimed in claim 1, wherein
the control unit
has a controller capable of performing processing for determining whether heating control is possible, for determining, on the basis of whether the output voltage of the power source unit has fallen below a threshold voltage, whether heating control for heating the aerosol source to generate an aerosol is possible;
the threshold voltage is set in the controller; and
the control value modified in the control value modification processing includes the threshold voltage.

6. The power supply unit for an aerosol-generating device as claimed in claim 1, wherein
the control unit has a charging IC configured to be capable of controlling charging of the power source unit by means of power received from an external power source;
an end-of-charging voltage, which is a voltage value for ending charging of the power source unit, is set in the charging IC, and
the control value modified in the control value modification processing includes the end-of-charging voltage.

7. The power supply unit for an aerosol-generating device as claimed in claim 1, wherein
the power supply unit has a protection IC that protects the power source unit from overcharge, overdischarge, overvoltage, overcurrent, and short circuit,
the control unit has a battery level indicator that measures the remaining charge of the power source unit;
in the battery level indicator, there are set:
an upper limit current for determining whether power discharged from the power source unit is overcurrent; and
an upper limit voltage for determining whether power discharged from the power source unit is overvoltage,
and
a forced stop current and a forced stop voltage are set in the protection IC,
the protection IC stops discharge from the power source unit when power discharged from the power source unit reaches or exceeds the forced stop current or the forced stop voltage,
the forced stop current is a value larger than the upper limit current,
the forced stop voltage is a value larger than the upper limit voltage, and
the control values not modified by the control value modification processing include at least one of the upper limit current and the upper limit voltage.

8. The power supply unit for an aerosol-generating device as claimed in any one of claims 1 to 7, wherein
the control unit
notifies a user that the power source unit has been correctly replaced and that the aerosol-generating device has become usable when the power source unit is correctly replaced and the aerosol-generating device becomes usable, and
modification of the control values used for controlling the power source unit is performed between the start and end of the notification.

9. The power supply unit for an aerosol-generating device as claimed in any one of claims 1 to 7, wherein
the control unit
prohibits charging and discharging of the power source unit during modification of the control values used for controlling the power source unit.

10. The power supply unit for an aerosol-generating device as claimed in any one of claims 1 to 7, wherein
the control unit temporarily stops implementation of the control value modification processing when the aerosol-generating device transitions to a state in which the power source unit can be removed while the control value modification processing is being implemented.
